(19)

Europäisches
Patentamt
European
Patent Office
Office européen
des brevets

(11) **EP 1 603 153 B1**

(12) **EUROPEAN PATENT SPECIFICATION**

(45) Date of publication and mention
of the grant of the patent:
**01.05.2013  Bulletin 2013/18**

(21) Application number: **04714029.8**

(22) Date of filing: **24.02.2004**

(51) Int Cl.:
**H01L 21/027** (2006.01)     **G03F 7/20** (2006.01)
**G01B 21/00** (2006.01)     **G01B 11/00** (2006.01)

(86) International application number:
**PCT/JP2004/002116**

(87) International publication number:
**WO 2004/077534 (10.09.2004 Gazette 2004/37)**

(54) **EXPOSURE METHOD, DEVICE PRODUCTION METHOD, AND INFORMATION DISPLAY METHOD**

BELICHTUNGSVERFAHREN, VERFAHREN ZUR HERSTELLUNG EINER VORRICHTUNG UND
VERFAHREN ZUR INFORMATIONSANZEIGE

PROCÉDÉ D'EXPOSITION, PROCÉDÉ DE FABRICATION D'UN DISPOSITIF ET PROCÉDÉ POUR
AFFICHER DES INFORMATIONS

(84) Designated Contracting States:
**AT BE BG CH CY CZ DE DK EE ES FI FR GB GR
HU IE IT LI LU MC NL PT RO SE SI SK TR**

(30) Priority: **26.02.2003  JP 2003049421**

(43) Date of publication of application:
**07.12.2005  Bulletin 2005/49**

(73) Proprietor: **NIKON CORPORATION**
**Chiyoda-ku**
**Tokyo 100-8331 (JP)**

(72) Inventor: **OKITA, Shinichi,**
**c/o Nikon Corporation I.P. Dept**
**Tokyo 100-8331 (JP)**

(74) Representative: **Wiebusch, Manfred**
**ter Meer Steinmeister & Partner GbR**
**Artur-Ladebeck-Strasse 51**
**33617 Bielefeld (DE)**

(56) References cited:
**JP-A- 6 224 103     JP-A- 6 232 028**
**JP-A- 8 097 114     JP-A- 9 115 817**
**JP-A- 9 218 714     JP-A- 2000 133 579**
**US-A- 5 863 680     US-A- 5 986 766**

Note: Within nine months of the publication of the mention of the grant of the European patent in the European Patent
Bulletin, any person may give notice to the European Patent Office of opposition to that patent, in accordance with the
Implementing Regulations. Notice of opposition shall not be deemed to have been filed until the opposition fee has been
paid. (Art. 99(1) European Patent Convention).

**Description**

**TECHNICAL FIELD**

The present invention relates to an exposure method for exposing a substrate suitable for use in a lithography process for production of for example a semiconductor device, liquid crystal display device, CCD, or other imaging device, a plasma display device, thin film magnetic head, or other electronic device (hereinafter simply referred to as an "electronic device") and an method of display of information. Further, the present invention relates to a method of production of a device using the exposure method.

In recent years, in the process of production of a semiconductor device or other electronic device, a step-and-repeat type, step-and-scan type, or other exposure apparatus, wafer prober, laser repair apparatus, etc. is used. In these devices, it is necessary to position (align) each of a plurality of chip pattern areas (shot areas) regularly arranged on a substrate in a two-dimensional matrix with a high accuracy with respect to predetermined reference positions. These reference positions are for example processing points or other positions defined for processing in different apparatuses and are defined by a stationary coordinate system defining the movement and position of a substrate under processing. Specifically, for example, they are defined by a Cartesian coordinate system defined by laser interferometers etc.

In an exposure apparatus, the semiconductor wafer or glass plate or other substrate has to be aligned with a high accuracy and stability with respect to the projected positions of patterns formed on the mask or reticle (hereinafter simply referred to as a "reticle"). In particular, in an exposure process of semiconductor devices, 10 or more layers of circuit patterns (reticle patterns) are transferred overlaid on a wafer. Therefore, if the overlay accuracy between the layers is poor, the characteristics of the circuits formed deteriorate. In the worst case, the semiconductor devices have to be discarded as defective and the overall yield is lowered.

Therefore, in the exposure process, marks arranged in advance at the shot areas on the wafer are used for wafer alignment. That is, alignment marks are arranged in advance at the plurality of shot areas on the wafer. At the time of exposure processing, first the position (coordinate values) on the stage coordinate system (stationary coordinate system) of the alignment mark in a shot area being exposed is detected. Further, the shot area is aligned with respect to the reticle pattern based on the position information of this alignment mark and the position information of a pre-measured reticle pattern.

There are roughly speaking two systems for wafer alignment. One is the die-by-die (D/D) alignment system for alignment by detecting an alignment mark for each shot area on a wafer. The other is the global alignment system for positioning each shot area by detecting alignment marks for only several shot areas on the wafer and finding the regularity of the alignment of the shot areas. At the present time, on the production lines of electronic devices, mainly the global alignment system is being used in view of the throughput. In particular, recently, the enhanced global alignment (EGA) system for detecting the regularity of alignment of the shot areas on the wafer at a high accuracy by statistical techniques is being extensively used (for example, Japanese Patent Publication No. S61-44429, Japanese Patent Publication No. S62-84516, etc.)

In the EGA system, the positional coordinates of only a plurality of shot areas selected in advance as specific shot areas (also referred to as "sample shot areas" or "alignment shot areas" in some cases) are measured in one wafer. The number of the shot areas has to be three or more and normally is 7 to 15 or so. From the measurement values of the positional coordinates at the specific shot areas, the positional coordinates of all of the shot areas on the -wafer (arrangement of shot areas) are calculated using the least square method or other statistical processing. Further, the wafer stage is moved in a stepping action in accordance with the calculated arrangement of the shot areas. Therefore, the EGA system has the advantage that the measurement time can be shortened and an effect of averaging random measurement error can be expected.

The method of statistical processing used in the EGA system of wafer alignment (hereinafter referred to as the "EGA") will be simply explained next.

A linear model such as shown in equation (1) is assumed for deviation ($\Delta Xn$, $\Delta Yn$) from design arrangement coordinates when the design arrangement coordinates of m (m is an integer of three or more) number of specific shot areas on a wafer are (Xn,Yn) (n=1, 2, ..., m).

$$\begin{pmatrix} \varDelta X_n \\ \varDelta Y_n \end{pmatrix} = \begin{pmatrix} a & b \\ c & d \end{pmatrix} \begin{pmatrix} X_n \\ Y_n \end{pmatrix} + \begin{pmatrix} e \\ f \end{pmatrix} \qquad \cdots (1)$$

When the deviations (measurement values) from the actual design arrangement coordinates of the m number of sample shot areas are ($\triangle$xn, $\triangle$yn), the sum of squares E of the differences between these deviations and the deviations ($\triangle$Xn, $\triangle$Yn) from the arrangement coordinates in the linear model shown in equation (1) is expressed by equation (2):

$$E = \Sigma \{ (\Delta x_n - \Delta X_n)^2 + (\Delta y_n - \Delta Y_n)^2 \} \qquad \cdots (2)$$

Therefore, the parameters a, b, c, d, e, and f are calculated to minimize the value E of equation (2). Further, the arrangement coordinates of all shot areas on the wafer are calculated based on the calculated parameters a to f and design arrangement coordinates (Xn.Yn).

In this way, the EGA system gives a linear primary approximation of the deviation between a design position and a position actually defined in the wafer and can correct the linear components of elongation, rotation, or other deviation of the wafer.

However, such deviation of the position of a wafer in the exposure process, that is, the overlay error, sometimes includes nonlinear components.

For example, on a production line of electronic devices, frequently the same electronic device is exposed by overlay exposure using a plurality of exposure apparatuses. In this case, usually there is error (stage grid error) between stage coordinate systems between exposure apparatuses. This sometimes causes nonlinear overlay error.

Further, the wafer suction holding mechanism or suction holding force etc. differs between exposure apparatuses. Due to this, sometimes distortion is given to the wafer. This distortion of the wafer also causes nonlinear deviation, that is, overlay error.

Further, the polishing, heat expansion, etc. in the etching, CVD (chemical vapor deposition), CMP (chemical mechanical polishing), or other processing quite often causes distortion at the wafer. Therefore, when exposing a layer after such a process, this distortion of the wafer causes nonlinear deviation, that is, overlay error. This overlay error due to the prior processing also occurs even with overlay exposure in the same exposure apparatus with no stage grid error.

As explained above, when the arrangement error of a shot area on a wafer causing overlay error (shot arrangement error) is a linear-like component, this can be eliminated by EGA. However, when the shot arrangement error is due to such stage grid error, distortion due to characteristics of the apparatuses, distortion due to processing, or other nonlinear wafer deformation, elimination by EGA is difficult. As explained above, in EGA, arrangement error of a shot area on a wafer is treated as being linear as shown in for example equation (1).

Therefore, for example the following method has been used for dealing with such nonlinear shot arrangement error.

For example, first, in the exposure sequence (main exposure processing), EGA measurement is performed again based on the EGA results to extract the nonlinear components. Further, the extracted nonlinear components are averaged for a plurality of wafers, and the average value is held as a map correction value. In the subsequent exposure sequences, this map correction value is used for correction of the exposure shot position.

Further, in the second method, separate from the exposure sequence, the nonlinear components (amounts of deviation for each shot) are measured for each exposure condition and process using a reference wafer and stored in a map correction file. In the exposure sequence, the map correction file in accordance with the exposure conditions is used for correcting the position of each shot area.

However, in the first method, EGA has to be performed for close to all of the shots on each wafer, so the problem arises of deterioration of the throughput.

Further, in the second method, a single map correction file is selected for each process (exposure condition) for correction of the nonlinear components, so there is the problem that the nonlinear components of each wafer cannot be corrected at the same exposure sequence.

US 5 986 766 A describes a global alignment method. As explained in US 5 986 766 A, for any design exposure position (x, y), deviations ($d_x'$, $d_y'$) from this position are predicted using a set of expression corresponding to equations (10). The parameters $a_{00}$, $b_{00}$ denote substrate displacements in the x- and y-directions respectively, $a_{10}$, $b_{01}$, denote substrate stretching/contraction in the x- and y-directions respectively and $a_{01}$, $b_{10}$ denote substrate rotations. The coefficients are determined by for example a least square method comparing the predicted deviations ($d_{xi}'$, $d_{yi}'$) for I=0,..., k measuring points with the measured deviations ($d_{xi}$, $d_{yi}$) for these points.

US 5 863 680 A discloses an exposure method wherein alignment correction parameters are dependent on differing alignment conditions.

DISCLOSURE OF THE INVENTION

An object of the present invention is to provide an exposure method enabling reduction of the nonlinear components of shot arrangement error and exposure maintaining a good overlay accuracy.

Still another object of the present invention is to provide a method of production of a device using an exposure process with a good overlay accuracy and a high throughput to enable production of a high quality electronic device efficiently, that is, with a high productivity, and such a high quality device.

To achieve these objects, the invention proposes an exposure method as defined in claim 1.

Preferably, the method uses the information of the differences between predetermined number calculated position information obtained by calculating position information of a predetermined number of areas among the plurality of areas and predetermined number measured position information obtained by measuring the predetermined number of areas so as to determine the plurality of coefficients of the predetermined calculation formula.

More preferably, the method further comprises determining the plurality of coefficients of the predetermined calculation formula so that the differences between the calculated position information and the measured position information become the minimum.

As a preferable example, the method further comprises determining the plurality of coefficients of the predetermined calculation formula so that the sum of squares of the differences between the calculated position information and the measured position information becomes the minimum.

Further, an alignment method not forming part of the present invention comprises using the calculation formula detected by any method as set forth above to calculate position information of the plurality of areas on the substrate and aligning the plurality of areas on the substrate with predetermined positions.

Further, the exposure method of the present invention is an exposure method transferring predetermined patterns to a plurality of areas formed on a substrate, comprising using the above alignment method to align the plurality of areas on the substrate with the predetermined patterns and transferring the predetermined patterns to the aligned areas.

Further, a method of production of a device of the present invention includes a step of using the above exposure method to transfer device patterns to a device substrate.

Further, an exposure method of the present invention is an exposure method aligning a plurality of areas formed on a substrate with predetermined patterns and exposing the plurality of areas by the predetermined patterns, comprising, in a registration period, using information of the differences between calculated position information obtained by using a first calculation formula provided with second or greater orders and a plurality of coefficients to calculate position information of the plurality of areas and measured position information of the plurality of areas measured in advance to determine the plurality of coefficients of the first calculation formula and storing a second calculation formula for which the plurality of coefficients are determined and, in a processing period after the registration period, reading out a stored second calculation formula, using the read out second calculation formula to calculate the position information of the plurality of areas on the substrate and, based on the calculated position information, aligning the plurality of areas with the predetermined patterns to transfer the predetermined patterns to the aligned areas.

Preferably, the further comprises, in an advanced processing period before the registration period, measuring the position information of the plurality of areas and storing the measured position information.

As a preferable example, the method further comprises, in the advanced processing period, measuring the position information of the plurality of areas and storing the measured position information measured in the advanced processing period.

As another preferable example, the method further comprises, after the advanced processing period and before the registration period, measuring the results of positioning between the plurality of areas on the substrate in the advanced processing period and the predetermined patterns and storing the measured position information based on the results of positioning.

More preferably, the method further comprises changing the alignment conditions and determining the coefficients of the second calculation formula for each condition in the registration period.

As a preferable example, the method further comprises changing the alignment conditions in accordance with the content of processing performed on the substrate.

As another preferable example, the method further comprises changing the alignment conditions by changing the first calculation formula.

As another preferable example, the method further comprises changing the alignment conditions by changing the number of the calculated position information used for determining the second calculation formula in the registration period and the measured position information.

As another preferable example, the method further comprises using information of the differences between calculated position information obtained by using a first calculation formula provided with a second or greater orders and a plurality of coefficients to calculate position information of a predetermined number of areas among the plurality of areas and measured position information of the read out predetermined number of areas to determine the first calculation formula and storing a second calculation formula for which the plurality of coefficients are determined and changing the alignment conditions by changing the arrangement of the predetermined number of areas.

As another preferable example, the method further comprises forming the measured position information of the plurality of areas by analysis of signal waveforms based on the results of detection of marks formed on the substrate corresponding to the plurality of areas and changing the alignment conditions by changing the method of analysis of the signal waveforms.

More preferably, the method further comprises, in the registration period, storing a plurality of the second calculation formulas for which coefficients are determined for each condition and, in the processing period, selecting a specific second calculation formula from the stored plurality of second calculation formulas and using the second calculation formula to calculate the position information for the plurality of areas on the substrate, aligning the plurality of areas with the predetermined patterns based on the calculated position information, and transferring the predetermined patterns to the aligned areas.

As a preferable example, the method further comprises, in the processing period, measuring the position information of the plurality of areas on the substrate and using information of the differences between measured position information of the plurality of areas and calculated position information obtained by using the stored plurality of the second calculation formulas to calculate position information of the plurality of areas so as to select a specific second calculation formula from the plurality of second calculation formulas.

As another preferable example, the method further comprises, in the processing period, detecting information on the trends in arrangement of a plurality of areas on the substrate in the processing period and selecting a specific second calculation formula from the plurality of second calculation formulas based on the detected information of arrangement trends.

Preferably, the exposure method further comprises, in the registration period, using information of the differences between the calculated position information obtained by using a plurality of second calculation formulas for which coefficients are determined for each condition to calculate the position information of the plurality of areas and the measured position information so as to selectively store a specific second calculation formula.

Further, another exposure method of the present invention is an exposure method aligning a plurality of areas formed on a substrate with-predetermined patterns and exposing the plurality of areas by the predetermined patterns, comprising, in a registration period, changing the alignment conditions, using the information of the differences between calculated position information obtained by using a first calculation formula provided with a second or greater orders and a plurality of coefficients for each condition to calculate the position information of the plurality of areas and measured position information of the plurality of areas so as to determine the plurality of coefficients of the first calculation formula and registering these as second calculation formulas, and, in a processing period after the registration period, using the second calculation formulas to calculate position information of the plurality of areas on a substrate, using the calculated position information to align the plurality of areas with the predetermined patterns, and transferring the predetermined patterns to the aligned areas.

Preferably, the method further comprises changing the alignment conditions in accordance with the content of processing performed on the substrate.

More preferably, the method further comprises changing the alignment conditions by changing the first calculation formula.

As another preferable example, the method further comprises changing the alignment conditions by changing the number of the calculated position information used for determining the second calculation formula in the registration period and the number of the measured position information.

As another preferable example, the method further comprises, in the registration period, changing the alignment conditions, using the information of the differences between calculated position information obtained by using a first calculation formula provided with a second or greater orders and a plurality of coefficients for each condition to calculate position information of a predetermined number of areas among the plurality of areas and measured position information of the predetermined number of areas stored in advance so as to determine the plurality of coefficients of the first calculation formula and storing this as a second calculation formula, and changing the alignment conditions by changing the arrangement of the predetermined number of areas.

As another preferable example, the method further comprises forming the measured position information of the plurality of areas by analysis of signal waveforms based on the results of detection of marks formed on the substrate corresponding to the plurality of areas and changing the alignment conditions by changing the method of analysis of the signal waveforms.

Preferably, the method further comprises, in the registration period, storing a plurality of the second calculation formulas and, in the processing period, selecting a specific second calculation formula from the stored plurality of second calculation formulas and using the selected second calculation formula to calculate the position information for the plurality of areas on the substrate, aligning the plurality of areas with the predetermined patterns based on the calculated position information, and transferring the predetermined patterns to the aligned areas.

As a preferable example, the method further comprises, in the processing period, measuring the position information of the plurality of areas on the substrate and using information of the differences between the measured position information of the plurality of areas and calculated position information obtained by using the stored plurality of the second calculation formulas to calculate position information of the plurality of areas so as to select a specific second calculation formula from the plurality of second calculation formulas.

As another preferable example, the method further comprises, in the processing period, detecting information on the trends in arrangement of a plurality of areas on the substrate and selecting a specific second calculation formula from the plurality of second calculation formulas based on the detected information of arrangement trends.

More preferably, the method further comprises, in the registration period, using information of the differences between calculated position information obtained by using a plurality of second calculation formulas for which coefficients are determined for each condition to calculate the position information of the plurality of areas and the measured position information so as to selectively store a specific second calculation formula.

BRIEF DESCRIPTION OF THE DRAWINGS

FIG. 1 is a view of the configuration of an exposure system of an embodiment of the present invention,
FIG. 2 is a view of the configuration of an exposure apparatus of the exposure system shown in FIG. 1,
FIG. 3 is a view of the configuration of an alignment system of the exposure apparatus shown in FIG. 2,
FIG. 4a to 4t are views of specific examples of the trends in nonlinear deformation,
FIG. 5 is a flow chart for explaining processing for registering nonlinear deformation correction conditions according to the present invention,
FIG. 6 is a flow chart for explaining lot processing according to the present invention,
FIG. 7 is a view of sample shots of higher order EGA rough measurement in the lot processing shown in FIG. 6,
FIG. 8 is a flow chart for explaining the method of production of a device according to the present invention,
FIG. 9A is a first view of a modification of an exposure system of the present embodiment, and
FIG. 9B is a second view of a modification of an exposure system of the present embodiment.

BEST MODE FOR WORKING THE INVENTION

An embodiment of the present invention will be explained in detail with reference to the drawings.

Exposure System

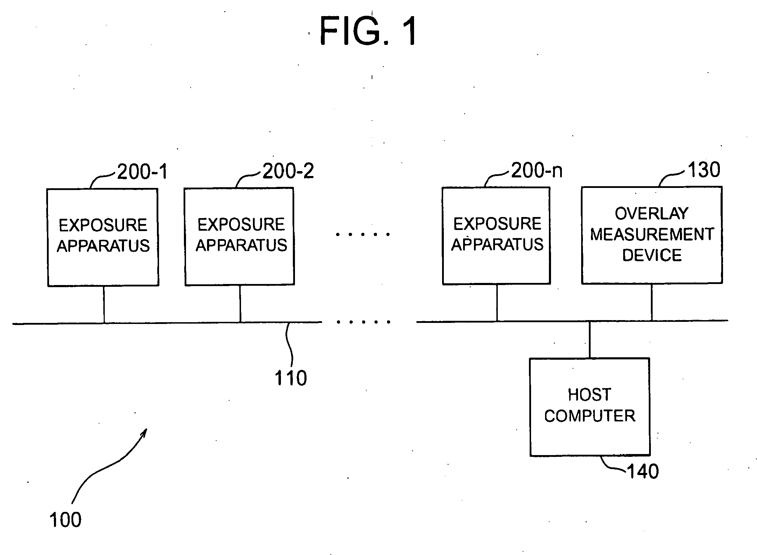

First, the overall configuration of an exposure system according to the present embodiment will be explained with reference to FIG. 1 to FIG. 3.

FIG. 1 is a view of the overall configuration of the exposure system 100 according to the present embodiment.

As shown in FIG. 1, the exposure system 100 has N number of exposure apparatuses 200-1 to 200-n, an overlay measurement device 130, and a host computer 140. These devices are connected by a LAN 110 so as to enable the transfer of data. Note that the LAN 110 may also have other processing devices, measurement devices, computers, etc. connected to it to enable transfer of data.

Each exposure apparatus 200-i (i=1 to n) (hereinafter simply referred to as an "exposure apparatus 200" in some cases) performs exposure processing on the wafers loaded in lot units (for example, 1 lot including 25 wafers) and successively forms patterns on them. That is, it positions each shot area defined on each wafer at a predetermined exposure position of the exposure apparatus 200, exposes it by exposure light passing through the reticle, and successively transfers the patterns formed on the reticle to that area.

At this time, in the exposure apparatus 200 according to the present invention, the alignment method according to the present invention enabling correction of nonlinear deviation for each shot area is used for alignment of each shot area.

The exposure apparatus 200 is connected through the LAN 110 to a host computer 140 controlling the exposure system 100 as a whole and successively processes the wafers for each lot based on instructions from the host computer 140.

Further, the exposure apparatus 200 is supplied from the host computer 140 with alignment conditions referred to at the time of alignment of the wafers and shot areas. The exposure apparatus 200 positions each wafer and shot areas based on the alignment conditions or further selects the optimum conditions from those conditions.

Further, the exposure apparatus 200 provides the host computer 140 with data (log data) of the results of positioning by the ordinary EGA system performed by the exposure apparatus 200 in accordance with need so the host computer 140 can find the alignment conditions.

In the present embodiment, the exposure apparatus 200 is made a step-and-scan type projection exposure apparatus (hereinafter referred to as a scan type exposure apparatus), but it may also be made a step-and repeat type projection exposure apparatus (stepper).

Note that the detailed configuration of the exposure apparatus 200, the method of detection of the alignment conditions, the EGA log data between the exposure apparatus 200 and host computer 140 relating to the same, the transfer of other data, etc. will be explained later in detail.

The overlay measurement device 130 measures the overlay error of a wafer successively formed with patterns by the exposure apparatus 200. The overlay measurement device 130 detects images of registration measurement marks (for example registration images) formed on the wafer, finds the difference in relative positions between marks formed at the time of exposure of different layers, and detects this as the overlay error. The overlay measurement device 130 is loaded with wafers formed with patterns and detects the state of overlay when analyzing the results of lot processing, in particular when measurement of overlay error is required.

As the processing according to the present invention, the overlay measurement device 130 measures the overlay for wafers loaded after going through specific processes and outputs the measurement results through the LAN 110 to the host computer 140. The data of the overlay measurement results is used by the host computer 140 to find the alignment conditions provided to the exposure apparatus 200 in the same way as the data of the EGA measurement results detected at the exposure apparatus 200.

The host computer 140 is a computer having a large capacity storage device and processing device and controls the overall lithography process in the exposure system 100.

Specifically, the host computer 140 has a large capacity storage device which stores information relating to the individual lots or individual wafers processed by the exposure system 100 such as various information for controlling the processes, various parameters or exposure history data, or other various information. Further, based on the information, it controls and manages the exposure apparatuses 200-1 to 200-n so that each lot is suitably processed.

Further, the host computer 140 finds the alignment conditions used for positioning processing in each exposure apparatus 200-i and registers these in each exposure apparatus 200-i. The host computer 140 finds the alignment conditions based on the EGA log data measured by the exposure apparatus 200 or the overlay result data measured by the overlay measurement device 130 or based on the pre-registered design position information or other information of the shot areas. One or more alignment conditions are found for each exposure apparatus-i or for each process performed for a lot under exposure. Note that when finding a plurality of alignment conditions, each exposure apparatus 200-i further selects and uses one optimum alignment condition. The method of detection of the alignment conditions will be explained in detail later.

Exposure Apparatus

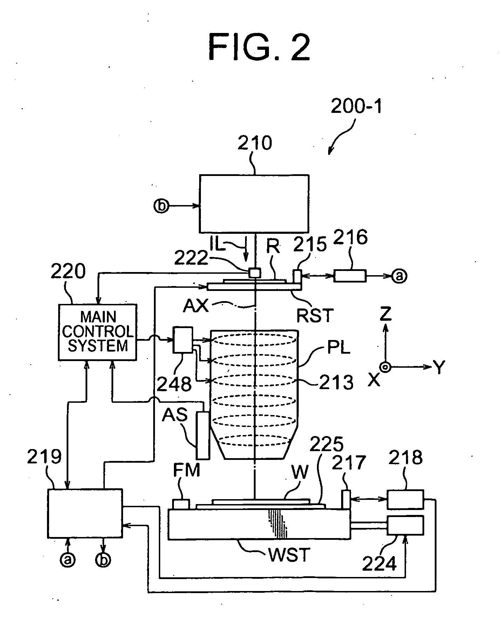

Next, the configuration of the exposure apparatus 200 will be explained with reference to FIG. 2.

FIG. 2 is a view of the general configuration of a scan type exposure apparatus as constituted by the exposure apparatus 200.

The exposure apparatus 200 is provided with an illumination system 210, a reticle stage RST holding a mask constituted by a reticle R, a projection optical system PL, a wafer stage WST on which a substrate constituted by a wafer W is carried, an alignment system AS, a main control system 220 for controlling the apparatus as a whole, etc

The illumination system 210, as disclosed for example in Japanese Patent Publication No. H10-112433, Japanese Patent Publication No. H6-349701, etc., has a light source, an optical integrator constituted by a luminance leveling optical system including a fly eye lens or rod integrator (in-plane reflection type integrator), relay lens, variable ND filter, reticle blind, dichroic mirror, etc. (all not shown). The illumination system 210 illuminates the slit-shaped illumination areas defined by the reticle blinds on the reticle R drawn by the circuit patterns etc. by the illumination light IL by a substantially uniform luminance.

Note that as the illumination light IL, KrF excimer laser light (wavelength 248 nm) or other ultraviolet light, ArF excimer laser light (wavelength 193 nm), $F_2$ laser light (wavelength 157 nm), or other vacuum ultraviolet light, or ultraviolet band rays (grays, i-rays, etc.) from an extra-high voltage mercury lamp may be used.

The reticle stage RST has a reticle R fixed to it by for example vacuum suction holding. The reticle stage RST is designed to align the reticle R by a not shown reticle stage drive unit comprised of for example a magnetic levitation type two-way linear actuator by means of being able to be driven finely in the XY plane perpendicular to the optical axis of the illumination system 210 (matching with optical axis AX of later explained projection optical system PL) and by being able to be driven at a scan speed designated for a predetermined scan direction (here, made the Y-axis direction). Further, in the present embodiment, as the magnetic levitation type two-way linear actuator, one including not only a X-drive coil and Y-drive coil, but also a Z-drive coil is used, so the reticle stage RST can also be moved finely in the Z-axis direction.

The position of the reticle stage RST in the plane of movement of the stage is constantly detected by a reticle laser interferometer (hereinafter called a "reticle interferometer") 216 through a moving mirror 215 by a resolution of for example 0.5 to 1 nm. The position information of the reticle stage RST from the reticle interferometer 216 is supplied to the stage control system 219 and through it to the main control system 220. The stage control system 219 drives and controls the reticle stage RST in accordance with instructions from the main control system 220 based on position information of the reticle stage RST.

Above the reticle R, a pair of reticle alignment systems 222 (reticle alignment system at deep side of figure not shown) are arranged. Each of this pair of reticle alignment systems 222, while not shown here, is comprised of an oblique illumination system for illuminating marks for detection by illumination light of the same wavelength as the illumination light IL and an alignment microscope for obtaining images of the marks for detection. The alignment microscope includes an imaging optical system and imaging device. The imaging results from the alignment microscope are supplied to the main control system 220. In this case, not shown deflection mirrors for guiding the detection light from the reticle R to the reticle alignment systems 222 are arranged to be movable. When the exposure sequence is started, under the instruction of the main control system 220, not shown drive units are used to make the deflection mirrors retract to the outsides of the paths of the illumination light IL together with the reticle alignment systems 222.

The projection optical system PL is arranged under the reticle stage RST in FIG. 2. The direction of its optical axis AX is made the Z-axis direction. As the projection optical system PL, for example, a double telecentric reduction system is used. The projection rate of this projection optical system PL is 1/4, 1/5, 1/6, etc. Therefore, if the illumination light IL from the illumination system 210 is used to illuminate the illumination area of the reticle R, the illumination light IL passing through this reticle R is used to form a reduced image (partially inverted image) of the circuit patterns of the reticle R in the illumination area through the projection optical system PL on the surface of the wafer W on which the resist (photosensitizer) is coated.

As the projection optical system PL, a refraction system comprised of only a plurality of, for example 10 to 20, refractive optical devices (lens devices) 213 as shown in FIG. 2 is used. Among the plurality of lens devices 213 forming this projection optical system PL, the plurality of lens devices at the object side (reticle R side) are movable lenses able to be driven to shift in the Z-axis direction (optical axis direction of projection optical system PL) and driven in a direction inclined from the XY plane (that is, a direction rotated about the X-axis and a direction rotated about the Y-axis) by not shown drive devices, for example, by piezoelectric actuators etc. Further, the imaging characteristic correction controller 248 independently adjusts the voltages supplied to the drive devices based on instructions from the main control system 220 so that the movable lenses are individually driven and the various imaging characteristics of the projection optical system PL (magnification, distortion, astigmatism, comatic aberration, image plane curvature, etc.) are adjusted. Note that, the imaging characteristic correction controller 248 can control the light source to shift the center wavelength of the illumination light IL and, in the same way as movement of the movable lenses, can adjust the imaging characteristics by shifting the center wavelength.

The wafer stage WST is arranged on a not shown base below the projection optical system PL in FIG. 2. This wafer stage WST has the wafer holder 225 placed on it. This wafer holder 225 has the wafer W fixed to it by for example vacuum suction holding etc. The wafer holder 225 is able to incline in any direction with respect to the plane perpendicular to the optical axis of the projection optical system PL by not shown drive units and to be able to move finely in the optical axis AX direction (Z-axis direction) of the projection optical system PL. Further, this wafer holder 225 can operate to be finely rotated about the optical axis AX.

The wafer stage WST is designed to move in not only the scan direction (Y-axis direction), but also to move in the non-scan direction (X-axis direction) perpendicular to the scan direction so as to enable a plurality of shot areas on the wafer W to be positioned at an exposure area conjugate with the illumination area. It engages in an operation to expose the shot areas on the wafer W by scanning and in a step-and-scan operation for movement to an acceleration start position for exposure of shot areas. This wafer stage WST is driven in the two X- and Y-directions by a wafer stage drive unit 224 including for example linear motors.

The position of the wafer stage WST in the XY plane is constantly detected through a moving mirror 217 provided on its top surface by a wafer laser interferometer system 218 at a resolution of for example 0.5 to 1 nm or so. Here, in actuality, the wafer stage WST is provided with a Y-moving mirror having a reflection surface perpendicular to the scan direction (Y-direction) and an X-moving mirror having a

reflection surface perpendicular to the non-scan direction (X-axis direction). Corresponding to this, the wafer laser interferometer 218 is provided with a Y-interferometer emitting an interferometer beam perpendicular to the Y-moving mirror and an X-interferometer emitting an interferometer beam perpendicular to the X-moving mirror. In FIG. 2, however, these are shown as the moving mirror 217 and wafer laser interferometer system 218. That is, in the present embodiment, a stationary coordinate system (Cartesian coordinate system) defining the movement position of the wafer stage WST is defined by the measurement axes of the Y-interferometer and X-interferometer of the wafer laser interferometer system 218. Below, this stationary coordinate system will also be referred to as a "stage coordinate system". Note that the end faces of the wafer stage WST may also be polished to a mirror finish to form reflection surfaces for the above-mentioned interferometer beams.

The position information (or speed information) on the stage coordinate system of the wafer stage WST is supplied to the stage control system 219 and through this to the main control system 220. The stage control system 219 controls the wafer stage WST through the wafer stage drive unit 224 in accordance with instructions of the main control system 220 based on the position information (or speed information) of the wafer stage WST.

Further, the wafer stage WST has a fiduciary mark plate FM fastened to it near the wafer W. The surface of this fiduciary mark plate FM is set to the same height as the surface of the wafer W. This surface is formed with fiduciary marks for so-called baseline measurement, fiduciary marks for reticle alignment, and other fiduciary marks of a later explained alignment system.

The projection optical system PL is provided at its side with an off-axis type alignment system AS. As this alignment system AS, here, for example, an alignment sensor on Field Image Alignment (FIA) system such as disclosed in Japanese Patent Publication No. H2-54103 is used. This alignment system AS emits illumination light having a predetermined wavelength band (for example, white light) to the wafer and detects the images of the alignment marks on the wafer and the images of index marks on an index plate formed in a plane conjugate with the wafer formed by an object lens etc. on the light receiving surface of an imaging device (CCD camera etc.) The alignment system AS outputs the imaging results of the alignment marks (and fiduciary marks on the fiduciary mark plate FM) toward the main control system 220.

The exposure apparatus 200 is further provided with an oblique incidence type multipoint focus detection system comprised of a not shown emitting optical system for supplying imaging beams for forming a plurality of slit images toward the best imaging plane of the projection optical system PL in an oblique direction with respect to the direction of the optical axis AX and a not shown receiving optical system for receiving the imaging light beams reflected from the surface of the wafer W through the slits and fastened to a support (not shown) supporting the projection optical system PL. As this multipoint focus detection system, one of a configuration similar to that disclosed in for example Japanese Patent Publication No. H5-190423, Japanese Patent Publication No. H6-283403, etc. is used. The stage control system 219 drives the wafer holder 225 in the Z-axis direction and direction of inclination based on the wafer position information from this multipoint focus detection system.

The main control system 20 is configured including a microcomputer or workstation and centrally controls the components of the apparatus. The main control system 220 is connected to the above-mentioned LAN 110. Further, in the present embodiment, the hard disk or other storage device or RAM or other memory forming part of the main control system 220 stores a plurality of types of correction conditions (correction coefficients) prepared in advance as a database.

Alignment System

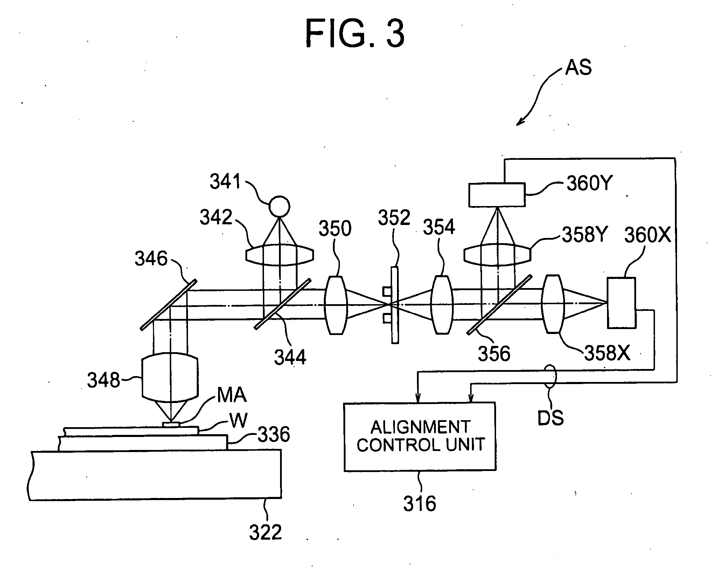

Next, the configuration of the alignment system AS will be explained with reference to FIG. 3.

As shown in FIG. 3, the alignment system AS has a light source 341, collimater lens 342, beam splitter 344, mirror 346, object lens 348, condensing lens 350, index plate 352, first relay lens 354, beam splitter 356, X-axis second relay lens 358X, X-axis imaging device 360X comprised of a two-dimensional CCD, Y-axis second relay lens 358Y, and Y-axis imaging device 360Y comprised of a two-dimensional CCD.

As the light source 341, a light source emitting non-photosensitizing light not photosensitizing the photo resist on the wafer and having a broad wavelength distribution having a certain bandwidth (for example 200 nm or so), here, a halogen lamp, is used. To prevent a drop in the accuracy of mark detection due to thin-film interference at the resist layer, broadband illumination light is used.

The illumination light from the light source 341 travels via the collimater lens 342, beam splitter 344, mirror 346, and object lens 348 to near an alignment mark MA on the wafer W. The light reflected from the alignment mark MA travels via the object lens 348, mirror 346, beam splitter 344, and condensing lens 350 to the index plate 352, whereby the index plate 352 is formed with an image of the alignment mark MA.

The light passing through the index plate 352 travels via the first relay lens 354 toward the beam splitter 356. The light passing through the beam splitter 356 is focused by the X-axis second relay lens 358X on the imaging surface of the X-axis imaging device 360X, while the light reflected at the beam splitter 356 is focused on the imaging surface of the Y-axis imaging device 360Y by the Y-axis second relay

lens 358Y. The imaging surfaces of the imaging devices 360X and 360Y are formed with images of the alignment mark MA and images of the index mark of the index plate 352 superposed. The imaging signals (DS) of the imaging devices 360X and 360Y are supplied to the main control system 220.

The main control unit 220 is also supplied with measurement values of the wafer laser interferometer 218 through the stage control system 219. Therefore, the main control unit 220 calculates the position of an alignment mark MA on the stage coordinate system based on the imaging signal DS from the alignment system AS and the measurement value of the wafer laser interferometer 218.

Exposure Processing Sequence

Next, the method and flow of exposure processing of the exposure system 100 of the present embodiment will be explained focusing on the wafer alignment method and sequence according to the present invention.

In the exposure system 100 of the present embodiment, before the period for exposure processing (processing period), first the exposure apparatus 200 selects the correction condition for correcting the nonlinear error at the time of positioning in the host computer 140 and registers this in the exposure apparatus 200 (processing for registration of nonlinear error correction condition).

After the correction condition is registered, the exposure apparatus 200 uses the registered correction condition for successive aligning and shot exposure processing for each lot, each wafer, and each shot (lot processing).

Processing for Registration of Nonlinear Error Correction Conditions

The processing for registration of the nonlinear error correction condition, as explained above, selects one or more correction conditions preferable for correction of the nonlinear shot arrangement error and registers them at the exposure apparatus 200.

The one or more correction conditions are registered corresponding to the process condition of the lot for lot processing at the exposure apparatus 200, that is, for each process condition.

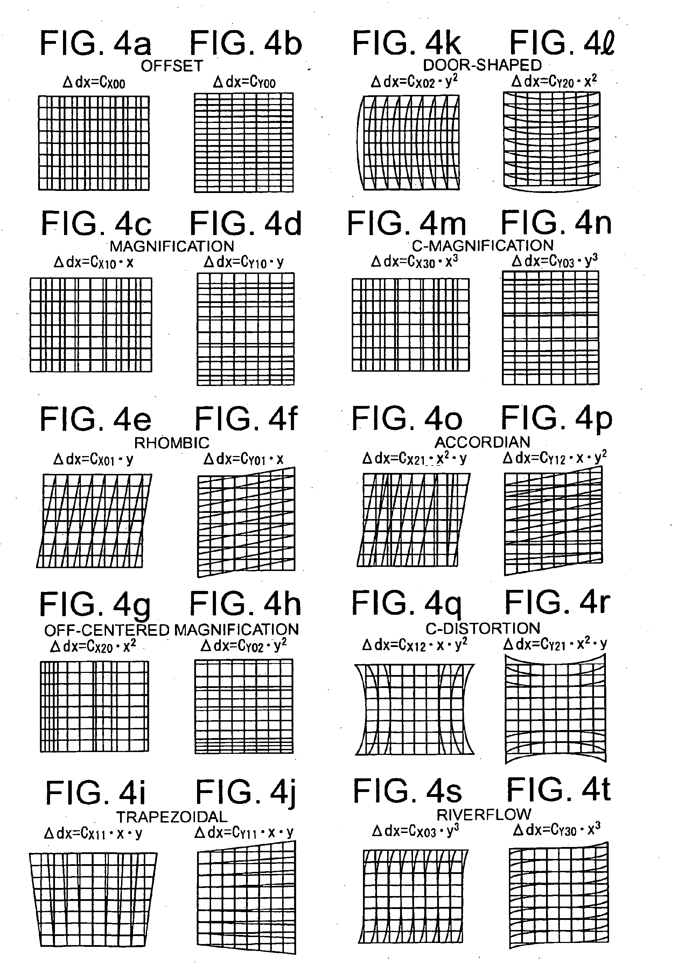

In general, several types of components of nonlinear deformation for example as shown in FIG. 4 corresponding to the reasons for the deformation may be considered. As the reasons, as explained above, there are stage grid error inherent to the exposure apparatus or polishing apparatus or other apparatus, distortion due to mechanical pressure at the time of the processing operation, inherent distortion occurring for each process, etc. Therefore, each lot with the same history of previous processing, exposure conditions of the current exposure processing, and other conditions often suffer from the same nonlinear deformation or the same trend in nonlinear deformation. Therefore, the correction conditions for correction of the deformation are registered for each process condition.

In selecting the correction conditions, a plurality of conditions including calculation models of correction formulas are designated and pre-measured history data is applied to the conditions so as to find the correction coefficients of the calculation model for each condition and thereby find the correction conditions. Further, among the correction conditions for the plurality of designated conditions, one or more correction conditions with little residual component in the case of application to history data are selected and registered at the exposure apparatus 200.

As the designation of the condition for finding the correction conditions, in the present embodiment, the conditions of the EGA calculation model, order condition, and correction coefficient are considered.

As the EGA calculation model, a six-parameter model, 10-parameter model, in-shot averaging model, or other calculation model may be considered. However, the models able to be designated are limited in accordance with the number of measurement points in a shot. When there is one measurement point in a shot, .normally the six-parameter model is designated. Further, in the case of a model with numerous measurement points in a shot, the 10-parameter model, in-shot averaging model, and six-parameter model using any single point in a shot may be designated.

As the order condition, the highest order used such as up to the second order term, third order term, or fourth order term, is designated.

By designating the EGA calculation model and order -condition, the correction formula is determined.

For example, when designating the highest order third order by a 10-parameter model, the shot alignment deformation calculation model shown in equation (3) and equation (4) is used, while when designating the second order, the shot alignment deformation calculation model shown in equation (5) and equation (6) is used.

$$\Delta X = C_{x30}W_x{}^3 + C_{x21}W_x{}^2W_y + C_{x12}W_xW_y{}^2 + C_{x03}W_y{}^3$$
$$+ C_{x20}W_x{}^2 + C_{x11}W_xW_y + C_{x02}W_y{}^2$$
$$+ C_{x10}W_x + C_{x01}W_y$$
$$+ C_{x00}$$
$$+ C_{xsx}S_x + C_{xxy}S_y \quad \ldots (3)$$

$$\Delta Y = C_{y30}W_x{}^3 + C_{y21}W_x{}^2W_y + C_{y12}W_xW_y{}^2 + C_{y03}W_y{}^3$$
$$+ C_{y20}W_x{}^2 + C_{y11}W_xW_y + C_{y02}W_y{}^2$$
$$+ C_{y10}W_x + C_{y01}W_y$$
$$+ C_{y00}$$
$$+ C_{ysx}S_x + C_{yxy}S_y \quad \ldots (4)$$

$$\Delta X = C_{x20}W_x{}^2 + C_{x11}W_xW_y + C_{x02}W_y{}^2$$
$$+ C_{x10}W_x + C_{x01}W_y$$
$$+ C_{x00}$$
$$+ C_{xsx}S_x + C_{xxy}S_y \quad \ldots (5)$$

$$\Delta Y = C_{y20}W_x{}^2 + C_{y11}W_xW_y + C_{y02}W_y{}^2$$
$$+ C_{y10}W_x + C_{y01}W_y$$
$$+ C_{y00}$$
$$+ C_{ysx}S_x + C_{yxy}S_y \quad \ldots (6)$$

In equation (3) to equation (6), $W_x$ and $W_y$ show positions of the shot center using the wafer center as the origin, $S_x$ and $S_y$ show positions of the measurement point using the shot center as the origin, and $\Delta X$ and $\Delta Y$ show the distances to be corrected, that is, the positional deviations. However, when not using a shot component, that is, not using the coordinates $S_x$ and $S_y$ in the shot, $W_x$ and $W_y$ are positions of the measurement points using the wafer center as the origin.

The condition for the correction coefficients is for example stabilizing the results of higher order correction by excluding the high correlation correction coefficients, that is, setting 0. For example, in the case of a third order term, by excluding the terms $W_x{}^2W_y$ and $W_xW_y{}^2$ from the coefficients $W_x{}^3$, $W_x{}^2W_y$, $W_xW_y{}^2$, and $W_y{}^3$, stable results of higher order correction can be obtained in some cases. The higher the order, the more effective designation of exclusion of the high correlation correction coefficients in some cases. This condition is designated by several variations.

Note that in the present embodiment, as conditions for finding the correction conditions, the above-mentioned EGA calculation model, order condition, and condition of the correction coefficients were used, but various other conditions may also be considered. For example, the number of sample shots of the EGA rough measurement used when selecting correction conditions in the later explained lot processing and the arrangement of the sample shots may also be used. Further, the condition of being a reference substrate system for alignment based on a reference wafer or an interferometer reference system for alignment based on an interferometer mirror may also be considered. Further, when the exposure apparatus is provided with an FIA type alignment system as in the present embodiment, the waveform analysis algorithm, slice level, contrast limit value, processing gate width, and condition of being an internal slope type or external slope type may be considered. Further, when the exposure apparatus is provided with an LSA type alignment system, the condition of setting the smoothing and slice level etc. may be considered, while when it is provided with an LIA type alignment system, the condition of the order of the diffraction light etc. may be considered. These conditions for finding the correction conditions may be freely set in a manner corresponding to the processing at the exposure apparatus and the changed conditions.

Further, as the history data referred to for selecting the correction conditions, either the EGA log file of the exposure apparatus or the log file of the results of overlay measurement is used.

The EGA log file of the exposure apparatus is data of position measurement by an exposure apparatus using ordinary EGA in past exposure processing using lot processing or a reference wafer under the same process conditions as when using the selected correction conditions.

Further, the overlay measurement file is data relating to the positional deviation obtained by positioning based on the results of position measurement, exposure, and measurement of the marks or registration images of the results by an overlay measurement device.

The correction coefficients corresponding to the designations of the different conditions are found by entering the measurement values of the plurality of shot positions for each wafer stored in the EGA log file or overlay measurement file into the calculation models of the different conditions to calculate the different coefficients (correction coefficients) and averaging these for a plurality of wafers. At this time, when there is aberrant data sufficiently separated from the other coefficient values in the found coefficient values, this is excluded when averaging the values. Further, since the measurement values of the shot positions used at this time are for calculating the trends in shot alignment deviation of the wafer as a whole, use is made of measurement values of a number of samples larger by a certain extent from the number of measured shots by ordinary linear EGA or the number of measured shots at the time of the later mentioned higher order EGA rough measurement or the measured values of all shots. By finding the correction coefficients in this way, the correction formula for nonlinear correction with respect to the measured shot positions is completed and the correction conditions are found.

After the correction conditions for the different designated conditions are found, a plurality of conditions actually giving small residual components after higher order EGA correction at these conditions are selected, the one giving the smallest residual component is selected, and this is registered in the exposure apparatus 200. The residual component is evaluated by the residual sum of squares.

When registering a plurality of correction conditions in the exposure apparatus 200 for use, higher order EGA rough measurement is performed at the time of lot processing to detect the nonlinear deformation at the lot, one correction condition is selected from the plurality of correction conditions based on the detection results, and this is used for nonlinear correction. More specifically, each of the plurality of correction conditions is applied to the measurement result of the higher order EGA rough measurement and the correction condition giving the smallest residual sum of squares is selected for use.

Both when registering only one correction condition or when registering a plurality of correction conditions, but designating a single correction condition at the stage of exposure processing, that single correction condition is used for processing of the lot. When the trend in nonlinear error at the process condition is clear and the optimum correction condition is known, this is effective in that nonlinear correction is possible by the minimum necessary extent of processing.

However, in the present embodiment, the conditions are changed in various ways to find the optimum correction coefficient for the set calculation model, and the correction condition including the calculation model, its correction coefficients, and other various conditions is registered in the exposure apparatus 200. However, if forcibly setting the correction coefficients to "0", the above-mentioned calculation model, the order condition, the condition of the correction coefficients, and the correction condition having the found correction coefficients finally can be boiled down to the issue of setting correction coefficients for the correction calculation formula having the highest order term in the 10-parameter model. That is, when the calculation algorithm of such a correction calculation formula is set in common at the exposure apparatus 200 as well, simply registering the correction coefficients in the exposure apparatus 200 becomes equivalent to registering the above-mentioned correction condition. Due to this, in the following explanation, registration of the correction condition in the exposure apparatus 200 will sometimes be referred to as simply setting the correction coefficients.

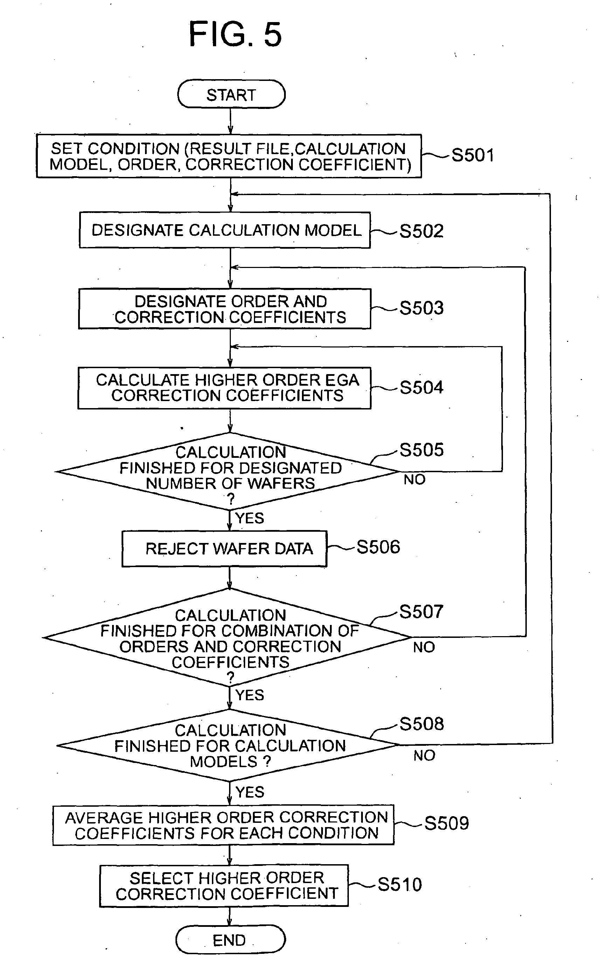

An example of the specific processing when performing the processing for selection and registration of the correction condition for nonlinear error by this method at the host computer 140 will be explained with reference to the flow chart shown in FIG. 5.

First, for setting the initial conditions, the various conditions for selecting the correction condition, that is, the calculation model to be considered, the condition of the order for optimization by the higher order EGA, and the condition of the correction coefficients for optimization by higher order EGA are set (step S501).

After setting the conditions, the conditions are successively designated, the EGA log file or overlay measurement file is referred to for the combinations of these conditions, and the higher order correction coefficients are calculated for a pre-designated predetermined number of wafers.

That is, first, the first calculation model is designated as the calculation model (step S502), the conditions of the order and correction coefficients are designated (step S503), and the higher order EGA correction coefficient is calculated (step S504). This is successively performed for a predetermined number of wafers (step S505).

After the higher order correction coefficients finish being calculated for a predetermined number of wafers (step S505), aberrant wafer data remarkably separate from the data is rejected (step S506), then the conditions of the order and correction coefficients are set (steps S507 and S503) and then the higher order EGA correction coefficients of a predetermined number of wafers are calculated by the next condition (step S504, S505).

Similarly, after calculating the higher order EGA correction coefficients for all of the set conditions of the order and correction coefficients (step S507), the calculation model is changed (steps S508 and S502), the next calculation model is used for successively setting the conditions of the order and correction coefficients again, and the higher order EGA correction coefficients for a predetermined number of wafers are calculated at each condition (-step S503 to S507).

Further, the higher order EGA correction coefficients of a predetermined number of wafers are calculated for all of the orders and correction coefficients of all of the set calculation models, that is, for all combinations of the optimization conditions (step S508), then the higher order EGA correction coefficients obtained for the wafers for each optimization condition are averaged (step S509). Note that at step S509, the data remaining after rejecting the aberrant wafer data at step S506 is used.

Further, the averaged higher order EGA correction coefficient is used to select a predetermined number of higher order EGA correction coefficients from those with small residual sums of squares after correction and these are registered at the exposure apparatus 200 (step S510). At this time, any condition among the conditions of the calculation model/order/correction coefficients may be registered or each condition of wafer deformation may be registered.

Note that the rejection operation of the aberrant wafer data at step S506 excludes wafer data with a residual sum of squares after higher order correction over a predetermined threshold value in the present embodiment. However, instead of the residual sum of squares, it is also possible to use as the threshold a decision coefficient (taking value of 0 to 1, the closer to 0, the greater the residual) obtained by dividing the dispersion of the higher order correction position by the dispersion of the measurement result position.

Exposure Processing (Lot Processing)

Each exposure apparatus 200-i set with an alignment correction condition for each process condition not only performs normal EGA processing including linear correction, but also higher order EGA correction, that is, nonlinear component correction, by the set correction condition to align the shot areas of the wafer.

In the present embodiment, normally the linear error as determined by the EGA is corrected by the following calculation model.

$$\Delta X = C_{x10}W_x + C_{x01}W_y + C_{xsx}S_x + C_{xsy}S_y + C_{x00} \qquad \ldots (7)$$

$$\Delta Y = C_{y10}W_x + C_{y01}W_y + C_{ysx}S_x + C_{ysy}S_y + C_{y00} \qquad \ldots (8)$$

$W_x$ and $W_y$ show positions of the shot center using the wafer center as the origin, $S_x$ and $S_y$ show positions of the measurement point using the shot center as the origin, and $\Delta X$ and $\Delta Y$ show the amounts of positional correction. However, when not using a shot component, that is, not using the coordinates $S_x$ and $S_y$ in the shot, $W_x$ and $W_y$ show positions of the measurement point using the wafer center as the origin.

Note that, in equation (7) and equation (8), among the coefficients, the coefficient $C_{x10}$ relates to the X-direction wafer scaling, the coefficient $C_{x01}$ to wafer rotation, the coefficient $C_{xsx}$ to X-direction shot scaling, the coefficient $C_{xsy}$

to shot rotation, the coefficient $C_{x00}$ to X-direction offset, the coefficient $C_{y01}$ to Y-direction wafer scaling, the coefficient $C_{y10}$ to wafer rotation, the $C_{ysx}$ to shot rotation, the coefficient $C_{ysy}$ to Y-direction shot scaling, and the coefficient $C_{y00}$ to Y-direction offset. Note that in terms of correspondence with the above-mentioned EGA, $-(C_{x10}+C_{y10})$ corresponds to the wafer perpendicularity, $-(C_{xsy}+C_{ysx})$ corresponds to the shot perpendicularity, $C_{y10}$ corresponds to the wafer rotation, and $C_{ysx}$ corresponds to the shot rotation.

Regarding higher order EGA correction, as explained above, when only a single correction condition is set for the process condition or when a plurality of correction conditions are set, but the correction condition to be used is designated, at the time of-lot processing, regardless of the trends in wafer deformation, that correction condition is used for the higher order EGA correction.

Further, when a plurality of correction conditions are set, higher order EGA rough measurement is used to detect the trends in nonlinear deformation of a wafer or lot, a single optimum correction condition is selected based on that, and higher order EGA correction is performed based on the selected correction condition.

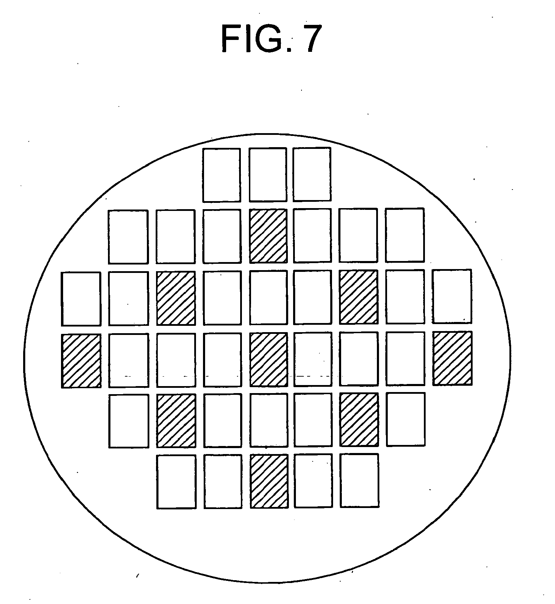

The higher order EGA rough measurement, as will be understood from the trends of shot arrangement, measures sample shots evenly and roughly designated over the entire region of the wafer. The number of the sample shots is greater than the number of shots measured at the time of usual EGA. As an example, nine shots are sampled as shown in FIG. 7.

Further, the optimum correction condition is selected by nonlinear correction of the higher order EGA rough shot measurement results for each of the registered plurality of correction conditions, in other words, application of the registered plurality of correction coefficients for higher order correction, and selection of the correction coefficient giving the smallest residual sum of squares.

Further, the higher order correction coefficients may also be calculated from the higher order EGA rough measurement results, and the coefficients matching the trends in shot arrangement deformation obtained from these may be selected from the registered plurality of correction coefficients.

Further, this higher order EGA rough measurement may be performed for all wafers of a lot, may be performed for a first predetermined number of wafers of each lot, or may be performed for every other pre-designated number of wafers. At this time, for a wafer not subjected to the higher order EGA rough measurement, it is preferable to use the correction coefficients selected in the higher order EGA rough measurement performed immediately before to perform higher order correction.

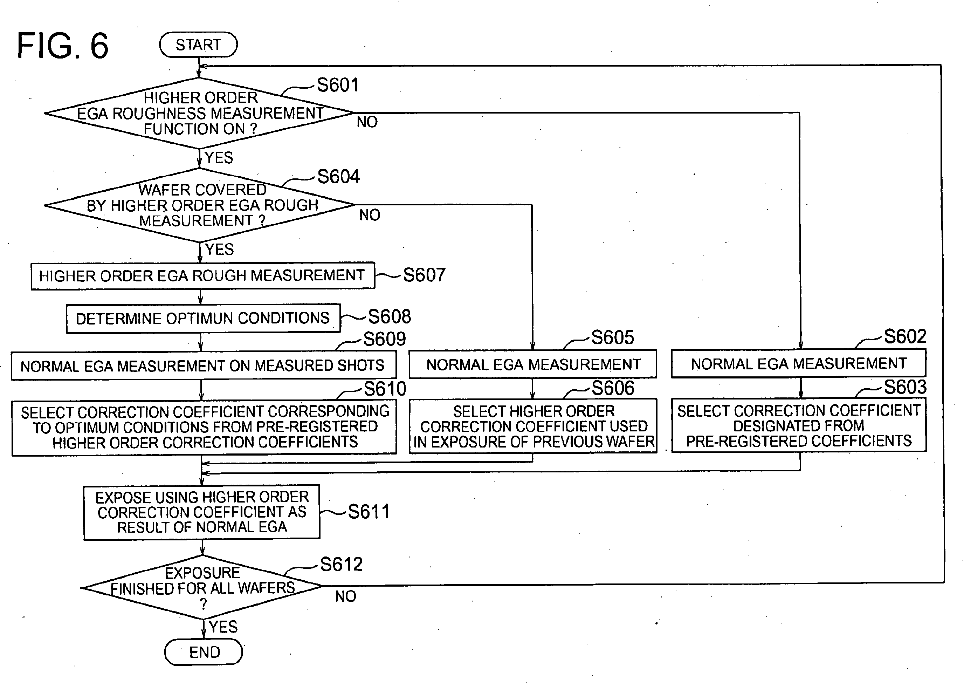

An example of the specific processing when performing such processing for aligning and exposure for each wafer including linear and nonlinear correction in the exposure apparatus 200 will be explained with reference to the flow chart shown in FIG. 6.

Note that in using the higher order EGA correction coefficients obtained as explained above, since the coefficients are obtained for the uncorrected residual error when the higher order EGA correction coefficients are calculated from the overlay measurement results, the exposure apparatus 200 uses these inverted in sign.

Further, when the obtained higher order correction coefficients are calculated from the EGA measurement results, since the linear components are corrected separately by the ordinary EGA, the 0-th and 1st components are corrected doubly. To prevent this, the 0-th and 1st correction coefficients calculated by ordinary EGA are subtracted from the 0-th -and 1st correction coefficients. At this time, the presence of any shot component is calculated by matching the conditions between the higher order EGA and ordinary EGA. For the correction coefficients of the higher order terms, the results of calculation of higher order EGA are used as they are.

Note that, even with higher order correction coefficients calculated from the EGA measurement results, when calculated separating the 2nd and greater higher order components and the 0-th and 1st lower order components separately, there is no need to subtract the results of ordinary EGA.

In the exposure apparatus 200, first it is judged if the higher order EGA rough measurement function is active (on) or inactive (off) (step S601). If inactive, the wafer is measured by ordinary EGA (step S602) and the higher order correction coefficients corresponding to the designated process condition are selected from the pre-registered higher order correction coefficients (step S603). Further, linear correction based on this ordinary EGA measurement result and nonlinear correction by fixed higher order correction coefficients corresponding to the selected process condition are applied for successive aligning and exposure of the shot areas (step S611).

When the higher order EGA rough measurement function is active (step S601), it is detected if the wafer being processed is a wafer to be covered by the higher order EGA rough measurement (step S604). Whether a wafer is covered by this higher order EGA rough measurement is set for any one or more wafers based on the wafer positions in the lot as explained above.

When the wafer being processed is not a wafer to be covered by the higher order EGA rough measurement (step S604), that wafer is measured by ordinary EGA measurement (step S605) and the higher order EGA correction coefficients used in the exposure of the immediately preceding wafer are selected (step S606). Further, linear correction based on the ordinary EGA measurement results and nonlinear correction by the selected higher order correction coefficients are applied for successive detection and correction of the shot areas, that is, alignment, and exposure (step S611).

Further, when the wafer covered by the processing is a wafer to be covered by higher order EGA rough measurement (step S604), higher order EGA rough measurement is performed on the measured shot 930 as shown by the hatching in for example FIG. 7 and the trends in shot arrangement deformation of the wafer 910 are detected (step S607). Next, based the detection results, the single optimum correction coefficient is selected from the plurality of higher order correction coefficients registered for that process condition (step S608). Further, linear correction based on this ordinary EGA measurement result and nonlinear correction by the selected higher order correction coefficient are applied for successive alignment and exposure of the shot areas (step S611).

In this way, the shot areas in a wafer are successively exposed and all wafers in the lot are exposed (step S612).

In this way, in the exposure system 100 of the present embodiment, the optimum nonlinear correction coefficient (correction condition) is selected in accordance with the trends in nonlinear deformation for each lot or for each wafer, whereby nonlinear deformation is corrected and positioning performed. Therefore, nonlinear error can be corrected in wafer units and accurate positioning is possible. As a result, high accuracy exposure is possible and high quality electronic devices can be produced.

Further, the correction coefficients are detected by detecting them and registering them in the exposure apparatus in the period before lot processing. Therefore, at the time of lot processing, huge processing for calculating the correction coefficients is not necessary. Rough EGA measurement for determining the trends in nonlinear deformation is sufficient. In the present embodiment, shot arrangement need only be measured for nine sample shots or slightly greater than the number of shots in ordinary EGA measurement. Therefore, the effect on the throughput can be suppressed to a minimum, the processing efficiency of the exposure processing can be maintained, and devices can be produced with a high productivity.

Further, the correction coefficients are selected base on the EGA log data or overlay measurement result data or other actual measurement data corresponding to the process condition. Therefore, it is possible to detect a suitable correction coefficient enabling suitable correction of nonlinear error and possible to achieve even more accurate alignment, high definition exposure processing, and production of high quality devices.

Note that when selecting the optimum condition in the processing for registration or exposure processing of the embodiment explained above, that is, when selecting one from the plurality of groups of higher order EGA correction coefficients, use of a function displaying the information forming the basis for calculation of the higher order coefficients such as the EGA measurement results, overlay measurement results, and the results of calculation using the found higher order EGA correction coefficients is effective for selection of the optimum conditions.

As the display format, it is preferable that display of the measurement values, correction values, residual error after correction using the higher order EGA correction coefficients, etc. can be switched for each shot area on a map like display such as shown in FIG. 7. Further, this map display preferably enables selective display of the average value for each wafer and for all wafers. Further, as the mode of display for each shot area, it is preferable that display of numerical data and display of a histogram can be selected.

Further, display of the signal waveforms such as disclosed in for example Japanese Patent Publication No. H4-324615 (Paragraph No. 0066) would be effective for selection of the optimum condition. As the content of the display of the signal waveforms, mark position information, mark detection results, mark detection parameters, mark shape parameters, wafer nos., shot nos., graph display scale, etc. may be mentioned.

Method of Production of Device

Next, a method of production of a device using the above-mentioned exposure system in a lithography process will be explained.

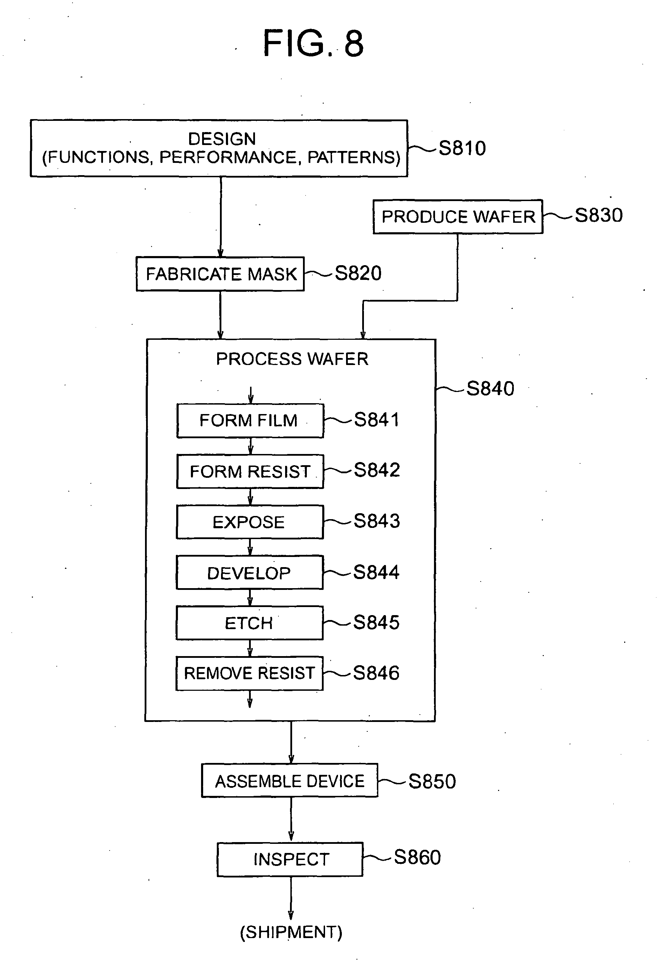

FIG. 8 is a flow chart of the process of production of for example an IC or LSI or other semiconductor chip, liquid crystal display panel, CCD, thin film magnetic head, micromachine, or other electronic device.

As shown in FIG. 8, in the process of production of an electronic device, first the circuits of the electronic device are designed or the functions and performances of the device are designed and the patterns for realizing these functions are designed (step S810), then a mask for forming the designed circuit patterns is fabricated (step S820).

On the other hand, silicon or another material is used to produce a wafer (silicon substrate) (step S830).

Next, the mask fabricated at step S820 and the wafer produced at step S830 are used for lithography etc. to form the actual circuits etc. on the wafer (step S840).

Specifically, first, the wafer is formed on its surface with an insulating film, electrode interconnect film, and semiconductor film as thin films (step S841), then the entire surface of these thin films is coated by a resist coating device (coater) with a photosensitizer (resist) (step S842).

Next, the substrate coated with this resist is loaded on a wafer holder of the exposure apparatus according to the present invention, the mask produced at step S830 is loaded on a reticle stage, then the patterns formed at the mask are reduced and transferred onto the wafer (step S843). At this time, in the exposure apparatus, the alignment method according to the present invention is used to successively align these at the shot areas of the wafer and successively transfer the patterns of the mask to the shot areas.

After the exposure ends, the wafer is unloaded from the wafer holder and a developing apparatus (developer) is used for development (step S844). Due to this, the wafer is formed on its surface with registration images of the mask patterns.

Further, the wafer finished being developed is etched using an etching device (step S845) and the resist remaining on the wafer surface is removed using for example a plasma ashing device etc. (step S846).

Due to this, each shot area of the wafer is formed with an insulating layer or electrode interconnects or other patterns. Further, this processing is successively repeated by changing the masks so that the wafer is formed with the actual circuits etc.

After the wafer is formed with the circuits etc., it is used to obtain individual devices (step S850). Specifically, the wafer is diced to individual chips which are then mounted in lead frames or packages, bonded with electrodes, and sealed in resin for packaging.

Next, the produced devices are tested to confirm their operation, tested for durability, and otherwise inspected (step S860) and then shipped out as finished devices.

Modifications

Note that the above embodiment was described for facilitating the understanding of the present invention and does not limit the present invention in any way. The elements disclosed in the embodiment include all design modifications or equivalents falling under the technical scope of the present invention and further can be modified in various preferable ways.

For example, the exposure system is not limited in overall configuration to the configuration shown in FIG. 1.

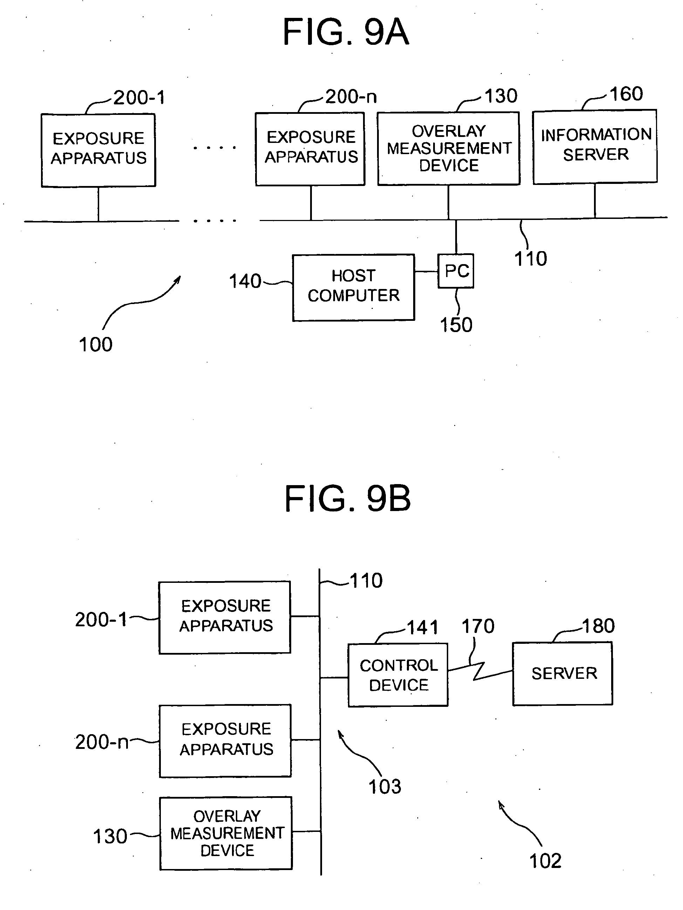

For example, as shown in the exposure system 101 shown in FIG. 9A, for example, a separate information server 160 may be provided for centrally storing the EGA measurement result data or overlay measurement results and correction coefficients in combination or other various information. Further, while not shown, other computers may be connected to the Intranet 110 to disperse the processing.

Further, as shown in FIG. 9B, the system may be constructed as a system constructed through a communications network 170 separate from the Intranet 110 or a so-called server client type system.

The exposure system 102 shown in FIG. 9B is connected with a factory system 103 and server 180 through an external communications network 170. The server 180 is equipped with the functions of the host computer 140 and information server 160 in the exposure system 101 of FIG. 9A. The factory system 103 has an exposure apparatus 200-i and overlay measurement device 130 for actually processing the wafer and a gateway device constituted by a communications control device 141 for connecting the external communications network 170 and Internet 110. Further, the external communications network 170 is for example the Intranet, a communications network using dedicated lines, etc.

This type of exposure system 102 is preferable when a management division is controlling or managing, for example, a factory system 103 arranged at a far off factory. Further, while not shown, it is preferable when controlling and managing a plurality of factory system 103 by a single server- 180. Further, it may also be applied to a system providing an environment for example for an exposure apparatus manufacturer maintaining characteristics or other information of an exposure apparatus 200 to decide on correction coefficients for a factory system 103 constructed at an electronic device manufacturer through a server 180.

In this way, the mode of sharing the processing for calculation and control and other processing at the different devices of the exposure system, in other words, the mode of sharing functions as a dispersed processing system, or the mode of connection of the devices as a network system may be any mode.

Further, in the present embodiment, as the alignment system, the case where an off-axis type FIA system (imaging type alignment system) was used was explained, but the invention is not limited to this. Any type of mark detection system may be used. That is, in addition to a TTR (Through The Reticle) system, TTL (Through The Lens) system, or any other off-axis type system and further an imaging system employing an FIA type detection system (image processing system), for example a system detecting diffraction light or scattered light may be used. For example, an alignment system emitting a coherent beam substantially vertical to an alignment mark on a wafer and causing interference with the same order of diffraction light ($\pm$1st order, $\pm$2n order, ......, $\pm$n-th order diffraction light) from the mark for detection may be used. In this case, it is also possible to independently detect the diffraction light for each order and use the detection results of at least one order or emit a plurality of coherent beams with different wavelengths to an alignment mark and cause interference with each order of diffraction light for each wavelength for detection.

Further, the present invention, as shown in the embodiments, is not limited to a step-and-scan type exposure apparatus and may be used in exactly the same way for various types of exposure apparatuses such as step-and-repeat type or proximity type exposure apparatuses (X-ray exposure apparatus etc.)

Further, the exposure illumination light (energy beam) used in the exposure apparatus is not limited to ultraviolet light and may also be X-rays (including EUV light), electron beams or ion beams or other charged particle beams etc. Further, the exposure apparatus may also be one used for production of a DNA chip, mask or reticle, etc.

According to the present invention, it is possible to provide an alignment method able to reduce the effect on throughput and enabling nonlinear correction for the optical shot alignment for each wafer and an optimum position detection type detection method for the same..

Further, it is possible to provide an exposure method able to reduce the nonlinear component of shot arrangement error and maintain a good overlay accuracy in exposure.

Further, it is possible to provide a method of production of a device which applies an exposure process with a good overlay accuracy and high throughput so as to enable high quality electronic devices to be produced efficiently, that is, with a high productivity and such a high quality device.

The present disclosure relates to subject matter contained in Japanese Patent Application No. 2003-049421, filed on February 26, 2003.

**Claims**

1. An exposure method aligning a plurality of areas formed on a substrate (W) with predetermined patterns and exposing said plurality of areas by said predetermined patterns, comprising,
   in a registration period (S607, S608),
   using information of the differences between calculated position information obtained by using a first calculation formula provided with a second or greater orders and a plurality of coefficients to calculate position information of the plurality of areas, and measured position information of said plurality of areas measured in advance to determine said plurality of coefficients of said first calculation formula and storing a second calculation formula for which said plurality of coefficients are determined, and
   in a processing period (S609 - S611) after said registration period, reading out the stored second calculation formula, using the read out second calculation formula to calculate the position information of said plurality of areas on said substrate and, based on said calculated position information, aligning said plurality of areas with said predetermined patterns to transfer said predetermined patterns to said aligned areas,
   wherein the coefficients determined in said registration period (S607, S608) are based on more measuring point data than the number of measuring points used in an aligning step (S609) in said processing period (S609 - S611).

2. An exposure method as set forth in claim 1, further comprising, in an advance processing period before said registration period, measuring said position information of the plurality of areas and storing said measured position information.

3. An exposure method as set forth in claim 1 or 2, further comprising, after said advanced processing period and before said registration period,
   measuring the results of positioning between said plurality of areas on said substrate (W) in said advance processing period and said predetermined patterns, and storing the measured position information based on the results of positioning.

4. An exposure method as set forth in claim 2, further comprising changing an alignment condition under which said plurality of areas on the substrate (W) is aligned with said predetermined patterns and determining the coefficient of said second calculation formula for each alignment condition in said registration period.

5. An exposure method as set forth in claim 4, further comprising changing said alignment condition in accordance with the processing performed on said substrate.

6. An exposure method as set forth in claim 4, further comprising changing said alignment condition by changing said first calculation formula.

7. An exposure method as set forth in claim 4, further comprising changing said alignment condition by changing the number of said calculated position information used for determining said second calculation formula in said registration period and said measured position information.

8. An exposure method as set forth in claim 4, further comprising:

   using information of the differences between calculated position information obtained by using a first calculation formula provided with a second or greater orders and a plurality of coefficients to calculate position information of a predetermined number of areas among said plurality of areas and measured position information of said read out predetermined number of areas to determine said first calculation formula and storing a second calculation formula for which said plurality of coefficients are determined and
changing said alignment conditions by changing the arrangement of said predetermined number of areas.

9. An exposure method as set forth in claim 4, further comprising:

forming the measured position information of said plurality of areas by analysis of signal waveforms based on the results of detection of marks formed on said substrate corresponding to said plurality of areas and
changing said alignment conditions by changing the method of analysis of said signal waveforms.

10. An exposure method as set forth in claim 4, further comprising, in said registration period,
storing a plurality of said second calculation formulas for which the coefficients are determined for each said condition, and
in said processing period,
selecting a specific second calculation formula from said stored plurality of second calculation formulas and using said second calculation formula to calculate the position information for said plurality of areas on said substrate, positioning said plurality of areas with said predetermined patterns based on said calculated position information, and transferring said predetermined patterns to said aligned areas.

11. An exposure method as set forth in claim 10, further comprising,
measuring said position information of the plurality of areas on said substrate in said processing period and
using information of the differences between measured position information of said plurality of areas and calculated position information obtained by using said stored plurality of said second calculation formulas to calculate position information of the plurality of areas so as to select a specific second calculation formula from the plurality of second calculation formulas.

12. An exposure method as set forth in claim 10, further comprising,
detecting information on the trends in arrangement of said plurality of areas on said substrate (W) in said processing period and
selecting a specific second calculation formula from the plurality of second calculation formulas based on the detected information of arrangement trends.

13. An exposure method as set forth in claim 4, further comprising, in said registration period, using information of the differences between said calculated position information obtained by using a plurality of second calculation formulas for which coefficients are determined for each condition to calculate said position information of the plurality of areas and said measured position information so as to selectively store a specific second calculation formula.

14. An exposure method as set forth in claim 1, wherein position information of a plurality of shot areas on a substrate (W) is calculated and predetermined patterns on each shot area are exposed while controlling the position of said substrate based on said calculated position information, including
a step (S501) of selecting at least one correction condition for correcting a nonlinear alignment error from a plurality of correction condition prepared in advance for each a plurality of process conditions for exposure processing of the substrate (W),
a step (S503) of selecting at least one second or higher order model formula from a plurality of formulas for which coefficients are determined stored in advance in a storage device,
a step of reading past data stored in advance on a storage device and relating to results of position control of the substrate (W) on which a first process is performed under a selected one of said process conditions,
a step (S504) of processing said position control results on the basis of data specifying said selected second or higher order model formula, said selected process condition, and said read position control results , and using the results of processing to find said coefficients of said second or higher order model formula, and calculating the second or higher order formula for finding position information of the plurality of shot areas on said substrate,
a step of repeating the step (S504) of calculating said second or higher order formula while changing at least one of said correction condition and said second or higher order model formula and storing in a storage device at least one of the calculated plurality of second or higher order formulas together with the process conditions linked with said first process,
a step of reading out data relating to results of past alignment of the substrate (W) subjected to a second process different from said first process and stored in advance in said storage device, calculating the second or higher order formula for said second process as well in the same way as calculating the second or higher order formula corresponding to said first process, and storing in a storage device the calculated second or higher order formula together with the process condition linked with said second process, and

when newly executing position control for the substrate (W) subjected to the first process, reading out the second or higher order formula and process conditions stored in said storage device linked with said first process, using said read out second or higher order formula and process conditions to find the position information of the plurality of shot areas on said substrate, and exposing predetermined patterns on the plurality of shot areas on said substrate while controlling the position of said substrate.

15. An exposure method as set forth in claim 14, wherein
the control of the position of said substrate includes a step of selectively using detection data of a predetermined number of shot areas among the plurality of shot areas on the substrate, and
said process conditions include an item relating to the number of shot areas in which the detection data is used.

16. An exposure method as set forth in claim 14, wherein
the control of the position of said substrate includes a step of selectively using detection data of shot areas formed in a predetermined arrangement among the plurality of shot areas on the substrate, and
said process conditions include an item relating to the arrangement of shot areas in which the detection data is used.

17. An exposure method as set forth in claim 14, wherein
the control of the position of said substrate includes a step of detecting the images of marks formed corresponding to a plurality of areas on the substrate, and
said process conditions include an item relating to the method of analysis of the signal waveform of said images.

18. An exposure method as set forth in claim 14, wherein said second or higher order model is one of a six-parameter model formula, 10-parameter model formula, and in-shot averaging model formula.

19. An exposure method as set forth in claim 14, wherein there are a plurality of sets of second or higher order formulas and process conditions stored in said storage device linked with processes for each process.

20. An exposure method as set forth in claim 19, further comprising,
when newly controlling the position of a substrate, detecting a specific number of shot areas among a plurality of areas formed on said substrate and
selecting a specific second or higher order formula and process condition from said plurality of sets of second or higher order formulas and process conditions stored in said storage device linked with processes based on the results of detection of said plurality of number of shot areas.

21. A method of production of a device by a substrate (W) exposed with predetermined patterns including a step of exposing said substrate with said predetermined patterns by an exposure method as set forth in any of the preceding claims.

22. A method of display of information relating to position control on a display screen in an exposure method calculating position information of a plurality of shot areas on a substrate (W) and exposing predetermined patterns on each shot area while controlling the position of said substrate based on said calculated position information, including
a step (S501) of selecting at least one correction condition for correcting a nonlinear alignment error from a plurality of correction conditions prepared in advance for each of a plurality of process conditions for exposure processing of the substrate (W),
a step (S503) of selecting at least one second or higher order model formula from a plurality of formulas for which coefficients are stored in advance in a storage device,
a step of reading past data stored in advance on a storage device and relating to results of position control of the substrate (W) on which a first process is performed under a selected one of said process conditions,
a step (S504) of processing said position control results on the basis of data specifying said selected second or higher order model formula, said selected process condition, and said read position control results, and using the results of processing to find said coefficients of said second or higher order model formula, and calculating the second or higher order formula for finding position information of the plurality of shot areas on said substrate,
a step of repeating the step (S504) of calculating said second or higher order formula while changing at least one of said correction condition and said second or higher order model formula and storing in a storage device at least one of the calculated plurality of second or higher order formulas together with the process condition linked with said first process,

a step of reading out data relating to results of past alignment of the substrate (W) subjected to a second process different from said first process and stored in advance in said storage device, calculating the second or higher order formula for said second process as well in the same way as calculating the second or higher order formula corresponding to said first process, and storing in a storage device the calculated second or higher order formula together with the process condition linked with said second process, and

when newly executing position control for the substrate (W) subjected to the first process, reading out the second or higher order formula and process condition stored in said storage device linked with said first process, using said read out second or higher order formula and process condition to find the position information of the plurality of shot areas on said substrate, and displaying said found position information on said display screen.

23. A method of display as set forth in claim 22, further comprising displaying the found position information together with an image of the substrate image and images of shot areas arranged on the image of said substrate image.

24. A method of display as set forth in claim 22, further comprising displaying the found position information by numerical values.

25. A method of display as set forth in claim 22, further comprising displaying a histogram based on the found position information.

26. An exposure method exposing predetermined patterns on a substrate including the display method as set forth in claim 22, wherein there are a plurality of sets of second or higher order formulas and process conditions stored in said storage device linked with processes for each process.

27. An exposure method as set forth in claim 26, further comprising selecting a specific second or higher order formula and process condition from said plurality of sets of second or higher order formulas and process conditions stored in said storage device linked with processes based on the position information displayed on said display screen.

**Patentansprüche**

1. Belichtungsverfahren, bei dem eine Mehrzahl von auf einem Substrat (W) gebildeten Gebieten mit vorbestimmten Mustern ausgerichtet werden und diese Mehrzahl von Gebieten mit den genannten vorbestimmten Mustern belichtet werden, mit,

in einer Registrierungsperiode (S607, S608),

Benutzen von Information über die Differenzen zwischen berechneter Positionsinformation, die erhalten wird durch Verwendung einer ersten Berechnungsformel, die von einer zweiten oder höheren Ordnung ist und eine Vielzahl von Koeffizienten zur Berechnung der Positionsinformation der mehreren Gebiete aufweist, und gemessener Positionsinformation über die mehreren Gebiete, die vorab gemessen wurde, um die genannte Mehrzahl von Koeffizienten der ersten Berechnungsformel zu bestimmen und eine zweite Berechnungsformel zu speichern, für welche die genannte Mehrzahl der Koeffizienten bestimmt ist, und,

in einer Bearbeitungsperiode (S609 - S611) nach der Registrierungsperiode, Lesen der gespeicherten zweiten Berechnungsformel, Benutzen der gelesenen zweiten Berechnungsformel zur Berechnung der Positionsinformation über die genannte Mehrzahl von Gebieten auf dem genannten Substrat und, auf der Grundlage dieser berechneten Positionsinformation, Ausrichten der genannten mehreren Gebiete mit den genannten vorbestimmten Mustern, um diese vorbestimmten Muster auf die ausgerichteten Gebiete zu übertragen,

wobei die in der genannten Registrierungsperiode (S607, S608) bestimmten Koeffizienten auf einer Anzahl von Messpunktdaten beruhen, die größer ist als die Anzahl der Messpunkte, die in einem Ausrichtschritt (S609) in der genannten Bearbeitungsperiode (S609 - S611) benutzt werden.

2. Belichtungsverfahren nach Anspruch 1, mit, in einer Vorbearbeitungsperiode vor der genannten Registrierungsperiode, Messen der genannten Positionsinformation über die Mehrzahl von Gebieten und Speichern der gemessenen Positionsinformation.

3. Belichtungsverfahren nach Anspruch 1 oder 2, weiter mit, nach der genannten Vorbearbeitungsperiode und vor der Registrierungsperiode,

Messen der Ergebnisse einer Positionierung zwischen der genannten Mehrzahl von Gebieten auf dem Substrat (W) in der Vorbearbeitungsperiode und den genannten vorbestimmten Mustern, und Speichern der gemessenen Positionsinformation auf der Grundlage der Ergebnisse der Positionierung.

4. Belichtungsverfahren nach Anspruch 2, weiter mit Ändern einer Ausrichtbedingung, unter welcher die genannte Mehrzahl von Gebieten auf dem Substrat (W) mit den genannten vorbestimmten Mustern ausgerichtet werden, und Bestimmen des Koeffizienten der genannten zweiten Berechnungsformel für jede Ausrichtbedingung in der Registrierungsperiode.

5. Belichtungsverfahren nach Anspruch 4, weiter mit Ändern der genannten Ausrichtbedingung in Übereinstimmung mit der Bearbeitung, die an dem Substrat vorgenommen wird.

6. Belichtungsverfahren nach Anspruch 4, weiter mit Ändern der genannten Ausrichtbedingung durch Verändern der genannten ersten Berechnungsformel.

7. Belichtungsverfahren nach Anspruch 4, weiter mit Ändern der Ausrichtbedingung durch Ändern der Anzahl der genannten berechneten Positionsinformationen, die benutzt werden zur Bestimmung der genannten zweiten Berechnungsformel in der Registrierungsperiode und der genannten gemessenen Positionsinformation.

8. Belichtungsverfahren nach Anspruch 4, weiter mit:

Benutzen von Information über die Differenzen zwischen berechneten Positionsinformationen, die Erhalten werden durch Verwendung einer ersten Berechnungsformel, die von einer zweiten oder höherer Ordnung ist und mehrere Koeffizienten zur Berechnung der Positionsinformation für eine vorbestimmte Anzahl von Gebieten unter der genannten Mehrzahl von Gebieten aufweist, und gemessener Positionsinformation über die genannte gelesene vorbestimmte Anzahl von Gebieten zur Bestimmung der ersten Berechnungsformel, und Speichern einer zweiten Berechnungsformel, für welche die genannten mehreren Koeffizienten bestimmt sind, und Ändern der Ausrichtbedingungen durch Ändern der Anordnung der genannten vorbestimmten Anzahl von Gebieten.

9. Belichtungsverfahren nach Anspruch 4, weiter mit:

Bilden der gemessenen Positionsinformation über die genannten mehreren Gebiete durch Analyse von Signalwellenformen auf der Grundlage von Resultaten der Detektion von Markierungen, die auf dem genannten Substrat entsprechend den genannten mehreren Gebieten gebildet sind, und
Ändern der genannten Ausrichtbedingungen durch Ändern des Verfahrens der Analyse der genannten Signalwellenformen.

10. Belichtungsverfahren nach Anspruch 4, weiter mit,
in der Registrierungsperiode,
Speichern mehrerer der genannten zweiten Berechnungsformeln, für welche die Koeffizienten bestimmt sind, für jede genannte Bedingung, und
in der Bearbeitungsperiode,
Auswählen einer spezifischen zweiten Berechnungsformel aus den genannten mehreren gespeicherten zweiten Berechnungsformeln, und Verwenden dieser zweiten Berechnungsformel zur Berechnung der Positionsinformation für die mehreren Gebiete auf dem Substrat, Positionieren dieser mehreren Gebiete mit den vorbestimmten Mustern auf der Grundlage dieser berechneten Positionsinformation, und Übertragen der vorbestimmten Muster auf die ausgerichteten Gebiete.

11. Belichtungsverfahren nach Anspruch 10, weiter mit,
Messen der Positionsinformation über die mehreren Gebiete auf dem Substrat in der Bearbeitungsperiode, und
Verwenden von Information über die Differenzen zwischen gemessener Positionsinformation über die mehreren Gebiete und berechneter Positionsinformation, die Erhalten wird durch Verwendung der genannten gespeicherten mehreren der zweiten Berechnungsformeln zur Berechnung der Positionsinformation über die mehreren Gebiete, um eine spezifische zweite Berechnungsformel unter der Mehrzahl der zweiten Berechnungsformeln auszuwählen.

12. Belichtungsverfahren nach Anspruch 10, weiter mit,
Detektieren von Information über die Trends in der Anordnung der mehreren Gebiete auf dem Substrat (W) in der Bearbeitungsperiode, und

Auswählen einer spezifischen zweiten Berechnungsformel aus der Mehrzahl der zweiten Berechnungsformeln auf der Grundlage der detektierten Information über Anordnungstrends.

13. Belichtungsverfahren nach Anspruch 4, weiter mit, in der Registrierungsperiode, Verwenden von Information über die Differenzen zwischen den berechneten Positionsinformationen, die unter Verwendung der mehreren zweiten Berechnungsformeln erhalten werden, für welche Koeffizienten für jede Bedingung zur Berechnung der genannten Positionsinformation der mehreren Gebiete bestimmt sind, und der gemessenen Positionsinformation, um selektiv eine spezifische zweite Berechnungsformel zu speichern.

14. Belichtungsverfahren nach Anspruch 1, bei dem Positionsinformation über mehrere Schussgebiete auf einem Substrat (W) berechnet wird und vorbestimmte Muster auf jedem Schussgebiet belichtet werden, während die Position des Substrats auf der Grundlage der berechneten Positionsinformation kontrolliert wird, mit
einem Schritt (S501) der Auswahl wenigstens einer Korrekturbedingung zur Korrektur eines nichtlinearen Ausrichtfehlers aus einer Mehrzahl von Korrekturbedingungen, die vorab vorbereitet wurden, für jede von mehreren Prozessbedingungen für die Belichtung des Substrats (W),
einem Schritt (S503) der Auswahl wenigstens einer Modellformel zweiter oder höherer Ordnung aus einer Mehrzahl von vorab in einer Speichereinrichtung gespeicherten Formeln, für welche Koeffizienten bestimmt sind,
einem Schritt des Lesens früherer Daten, die vorab in einer Speichereinrichtung gespeichert wurden und sich auf Resultate der Positionskontrolle des Substrats (W) beziehen, an dem eine erste Bearbeitung unter einer aus den genannten Prozessbedingungen ausgewählten Bedingung vorgenommen wird,
einem Schritt (S504) der Verarbeitung dieser Positionskontrollresultate auf der Basis von Daten, die die ausgewählte Modellformel zweiter oder höherer Ordnung, die genannte ausgewählte Prozessbedingung und die gelesenen Positionskontrollresultate spezifizieren, und Benutzen der Resultate der Bearbeitung zum Auffinden der Koeffizienten der Modelformel zweiter oder höherer Ordnung, und Berechnen der Formel zweiter oder höherer Ordnung zum Auffinden von Positionsinformationen über die mehreren Schussgebiete auf dem Substrat,
einem Schritt der Wiederholung des Schrittes (S504) der Berechnung der Formel zweiter oder höherer Ordnung unter Veränderung der genannten Korrekturbedingung und/oder der genannten Modellformel zweiter oder höherer Ordnung und Speichern wenigstens einer der berechneten mehreren Formeln zweiter oder höherer Ordnung in einer Speichereinrichtung zusammen mit den zu der ersten Bearbeitung gehörenden Prozessbedingungen,
einem Schritt des Lesens von Daten, die sich auf Resultate einer früheren Ausrichtung des Substrats (W), das einer von der ersten Bearbeitung verschiedenen zweiten Bearbeitung unterzogen wurde, beziehen und vorab in der genannten Speichereinrichtung gespeichert wurden, Berechnen der Formel zweiter oder höherer Ordnung auch für diese zweite Bearbeitung in der gleichen Weise wie die Berechnung der Formel zweiter oder höherer Ordnung entsprechend der ersten Bearbeitung, und Speichern der berechneten Formel zweiter oder höherer Ordnung in einer Speichereinrichtung zusammen mit der Prozessbedingung, die zu dieser zweiten Bearbeitung gehört, und wenn die Positionskontrolle für das Substrat (W), das der ersten Bearbeitung unterzogen wurde, erneut ausgeführt wird, Lesen der Formel zweiter oder höherer Ordnung und der Prozessbedingung, die in der genannten Speichereinrichtung gespeichert sind und mit der ersten Bearbeitung zusammenhängen, Verwenden der gelesenen Formel zweiter oder höherer Ordnung und der Prozessbedingungen zum Auffinden der Positionsinformation über die mehreren Schussgebiete auf dem Substrat, und Belichten vorbestimmter Muster auf die mehreren Schussgebiete auf dem Substrat bei gleichzeitiger Kontrolle der Position des Substrats.

15. Belichtungsverfahren nach Anspruch 14, bei dem
die Kontrolle der Position des Substrats einen Schritt der selektiven Verwendung von Detektionsdaten über eine vorbestimmte der Anzahl von Schussgebieten unter den mehreren Schussgebieten auf dem Substrat einschließt und die Prozessbedingung einen Faktor einschließt, der sich auf die Anzahl der Schussgebiete bezieht, in welchen die Detektionsdaten benutzt werden.

16. Belichtungsverfahren nach Anspruch 14, bei dem
die Kontrolle der Position des Substrats einen Schritt der selektiven Benutzung von Detektionsdaten von Schussgebieten einschließt, die unter den mehreren Schussgebieten auf dem Substrat in einer vorbestimmten Anordnung gebildet sind, und
die genannten Prozessbedingungen einen Faktor einschließen, der sich auf die Anordnung von Schussgebieten bezieht, in welchen die Detektionsdaten benutzt werden.

17. Belichtungsverfahren nach Anspruch 14, bei dem
die Kontrolle der Position des Substrats einen Schritt der Detektion der Bilder von Marken einschließt, die entsprechend einer Mehrzahl von Gebieten auf dem Substrat gebildet wurden, und

die Prozessbedingungen einen Faktor einschließen, der sich auf das Verfahren zur Analyse der Signalwellenform dieser Bilder bezieht.

18. Belichtungsverfahren nach Anspruch 14, bei dem das genannte Modell zweiter oder höherer Ordnung eine Modellformel mit sechs Parametern, eine Modellformel mit zehn Parametern oder eine Modellformel mit Mittelung innerhalb eines Schusses ist.

19. Belichtungsverfahren nach Anspruch 14, bei dem in der Speichereinrichtung mehrere Sätze von Formeln zweiter oder höherer Ordnung und Prozessbedingungen gespeichert sind, die mit Prozessen für jede Bearbeitung verbunden sind.

20. Belichtungsverfahren nach Anspruch 19, weiter mit,
wenn die Position eines Substrats erneut kontrolliert wird, Detektieren einer spezifischen Anzahl von Schussgebieten unter den mehreren auf dem Substrat gebildeten Schussgebieten, und
Auswählen einer spezifischen Formel zweiter oder höherer Ordnung und Prozessbedingung unter den mehreren Sätzen von Formeln zweiter oder höherer Ordnung und Prozessbedingungen, die in der Speichereinrichtung gespeichert sind, die und mit Prozesen in Verbindung steht, auf der Grundlage der Resultate der Detektion der genannten mehreren Anzahlen von Schussgebieten.

21. Verfahren zur Herstellung eines Bauelements aus einem Substrat (W), das mit vorbestimmten Mustern belichtet wird, mit einem Schritt der Belichtung des genannten Substrats mit den vorbestimmten Mustern nach einem Belichtungsverfahren gemäß einem der vorstehenden Ansprüche.

22. Verfahren zur Anzeige von Information, die sich auf Positionskontrolle bezieht, auf einem Anzeigeschirm in einem Belichtungsverfahren mit Berechnung von Positionsinformation über mehrere Schussgebiete auf einem Substrat (W) und Belichtung vorbestimmter Muster auf jedes Schussgebiet bei gleichzeitiger Kontrolle der Position des Substrats auf der Grundlage der berechneten Positionsinformation, mit
einem Schritt (S501) der Auswahl wenigstens einer Korrekturbedingung zur Korrektur eines nichtlinearen Ausrichtfehlers aus einer Mehrzahl von Korrekturbedingungen, die vorab vorbereitet wurden, für jede Prozessbedingung unter einer Mehrzahl von Prozessbedingungen für die Belichtung des Substrats (W),
einem Schritt (S503) der Auswahl wenigstens einer Modellformel zweiter oder höherer Ordnung aus einer Mehrzahl von Formeln, für welche Koeffizienten vorab in einer Speichereinrichtung gespeichert werden,
einen Schritt des Lesens früherer Daten, die vorab in einer Speichereinrichtung gespeichert wurden und sich auf Resultate der Positionskontrolle des Substrats (W) beziehen, an dem ein erster Prozess unter einer aus den mehreren Prozessbedingungen ausgewählten Prozessbedingung ausgeführt wird,
einem Schritt (S504) der Verarbeitung der Resultate der Positionskontrolle auf der Grundlage von Daten, die die ausgewählte Modellformel zweiter oder höherer Ordnung, die ausgewählte Prozessbedingung und die gelesenen Positionskontrollresultate spezifizieren, Verwenden der Resultate der Verarbeitung zum Auffinden der genannten Koeffizienten der Modellformel zweiter oder höherer Ordnung, und Berechnung der Formel zweiter oder höherer Ordnung zum Auffinden von Positionsinformationen für die mehreren Schussgebiete auf dem Substrat,
einem Schritt der Wiederholung des Schrittes (S504) der Berechnung der Formel zweiter oder höherer Ordnung bei Veränderung der genannten Korrekturbedingung und/oder der genannten Modellformel zweiter oder höherer Ordnung und Speichern wenigstens einer der berechneten mehreren Formeln zweiter oder höherer Ordnung in einer Speichereinrichtung zusammen mit der Prozessbedingung, die mit dem ersten Prozess in Verbindung steht,
einem Schritt des Lesens von Daten, die sich auf Resultate einer früheren Ausrichtung des Substrats (W) beziehen, das einem von dem ersten Prozess verschiedenen zweiten Prozess unterzogen wurde, und die vorab in der genannten Speichereinrichtung gespeichert wurden, Berechnen der Formel zweiter oder höherer Ordnung auch für den zweiten Prozess in der gleichen Weise wie bei der Berechnung der Formel zweiter oder höherer Ordnung, die dem ersten Prozess entspricht, und Speichern der berechneten Formel zweiter oder höherer Ordnung in der Speichereinrichtung zusammen mit der Prozessbedingung, die mit diesem zweiten Prozess in Verbindung steht, und
wenn die Positionskontrolle für das Substrat (W), das dem ersten Prozess unterzogen wird, erneut ausgeführt wird, Lesen der Formel zweiter oder höherer Ordnung und der Prozessbedingung, die in der Speichereinrichtung gespeichert sind und mit dem ersten Prozess in Verbindung stehen, Verwenden der gelesenen Formel zweiter oder höherer Ordnung und der Prozessbedingung zum Auffinden der Positionsinformation über die mehreren Schussgebiete auf dem Substrat, und Anzeigen der gefunden Positionsinformation auf dem Anzeigeschirm.

23. Verfahren nach zur Anzeige Anspruch 22, weiterhin mit Anzeigen der gefundenen Positionsinformation zusammen mit einem Bild des Substratbildes und Bildern von Schussgebieten, die auf dem Bild des Substratbildes angeordnet sind.

24. Verfahren zur Anzeige nach Anspruch 22, weiterhin mit Anzeige der gefundenen Positionsinformation durch numerische Werte.

25. Verfahren zur Anzeige nach Anspruch 22, weiterhin mit Anzeige eines Histogramms auf der Grundlage der gefundenen Positionsinformation.

26. Belichtungsverfahren zur Belichtung mehrerer vorbestimmter Muster auf ein Substrat, mit dem Anzeigeverfahren nach Anspruch 22, wobei mehrere Sätze von Formeln zweiter oder höherer Ordnung und Prozessbedingungen in der Speichereinrichtung gespeichert sind, die mit Prozessen für jeden Prozess in Verbindung steht.

27. Belichtungsverfahren nach Anspruch 26, weiterhin mit Auswahl einer spezifischen Formel zweiter oder höherer Ordnung und Prozessbedingung aus den mehreren Sätzen von Formeln zweiter oder höherer Ordnung und Prozessbedingungen, die in der Speichereinrichtung gespeichert sind, die mit Prozessen in Verbindung steht, auf der Grundlage der auf dem Anzeigeschirm angezeigten Positionsinformation.


**Revendications**

1. Procédé d'exposition alignant une pluralité de zones formées sur un substrat (W) avec des motifs prédéterminés et exposant ladite pluralité de zones par l'intermédiaire dudit motif prédéterminé, comportant,
au cours d'une période d'enregistrement (S607, S608),
d'utiliser des informations des différences entre des informations de position calculées obtenues en utilisant une première formule de calcul ayant un second ordre ou un ordre supérieur et une pluralité de coefficients pour calculer des informations de position de la pluralité de zones, et des informations de position mesurées de ladite pluralité de zones mesurées à l'avance afin de déterminer ladite pluralité de coefficients de ladite première formule de calcul et de mémoriser une seconde formule de calcul pour laquelle ladite pluralité de coefficients sont déterminés, et
au cours d'une période de traitement (S609 - S611) après ladite période d'enregistrement,
d'extraire la seconde formule de calcul mémorisée, d'utiliser la seconde formule de calcul extraite pour calculer les informations de position de ladite pluralité de zones sur ledit substrat et, sur la base desdites informations de position calculées, d'aligner ladite pluralité de zones avec lesdits motifs prédéterminés pour transférer lesdits motifs prédéterminés vers lesdites zones alignées,
dans lequel les coefficients déterminés au cours de ladite période d'enregistrement (S607, S608) sont basés sur plus de données de points de mesure que le nombre de points de mesure utilisés lors d'une étape d'alignement (S609) au cours de ladite période de traitement (S609 - S611).

2. Procédé d'exposition selon la revendication 1, comportant en outre, au cours d'une période de traitement préalable avant ladite période d'enregistrement, de mesurer lesdites informations de position de la pluralité de zones et de mémoriser lesdites informations de position mesurées.

3. Procédé d'exposition selon la revendication 1 ou 2, comportant en outre, après ladite période de traitement préalable et avant ladite période d'enregistrement,
de mesurer les résultats de positionnement entre ladite pluralité de zones sur ledit substrat (W) au cours de ladite période de traitement préalable et lesdits motifs prédéterminés, et de mémoriser les informations de position mesurées sur la base des résultats de positionnement.

4. Procédé d'exposition selon la revendication 2, comportant en outre de changer une condition d'alignement sous laquelle ladite pluralité de zones sur le substrat (W) sont alignées avec lesdits motifs prédéterminés et de déterminer le coefficient de ladite seconde formule de calcul pour chaque condition d'alignement au cours de ladite période d'enregistrement.

5. Procédé d'exposition selon la revendication 4, comportant en outre de changer ladite condition d'alignement conformément au traitement exécuté sur ledit substrat.

6. Procédé d'exposition selon la revendication 4, comportant en outre de changer ladite condition d'alignement en changeant ladite première formule de calcul.

**7.** Procédé d'exposition selon la revendication 4, comportant en outre de changer ladite condition d'alignement en changeant le nombre desdites informations de position calculées utilisées pour déterminer ladite seconde formule de calcul au cours de ladite période d'enregistrement et desdites informations de position mesurées.

**8.** Procédé d'exposition selon la revendication 4, comportant en outre :

d'utiliser des informations des différences entre des informations de position calculées obtenues en utilisant une première formule de calcul ayant un second ordre ou un ordre supérieur et une pluralité de coefficients pour calculer des informations de position d'un nombre prédéterminé de zones parmi ladite pluralité de zones et des informations de position mesurées dudit nombre prédéterminé extrait de zones afin de déterminer ladite première formule de calcul et de mémoriser une seconde formule de calcul pour laquelle ladite pluralité de coefficients sont déterminés, et
de changer lesdites conditions d'alignement en changeant l'agencement dudit nombre prédéterminé de zones.

**9.** Procédé d'exposition selon la revendication 4, comportant en outre :

de former les informations de position mesurées de ladite pluralité de zones en analysant des formes d'onde de signaux sur la base des résultats de détection de marques formées sur ledit substrat correspondant à ladite pluralité de zones, et
de changer lesdites conditions d'alignement en changeant le procédé d'analyse desdites formes d'onde de signaux.

**10.** Procédé d'exposition selon la revendication 4, comportant en outre, au cours de ladite période d'enregistrement, de mémoriser une pluralités desdites secondes formules de calcul pour lesquelles les coefficients sont déterminés pour chacune desdites conditions, et
au cours de ladite période de traitement,
de sélectionner une seconde formule de calcul parmi ladite pluralité de secondes formules de calcul mémorisées, et
d'utiliser ladite seconde formule de calcul pour calculer les informations de position pour ladite pluralité de zones sur ledit substrat, de positionner ladite pluralité de zones avec lesdits motifs prédéterminés sur la base desdites informations de position calculées, et de transférer lesdits motifs prédéterminés vers lesdites zones alignées.

**11.** Procédé d'exposition selon la revendication 10, comportant en outre,
de mesurer lesdites informations de position de la pluralité de zones sur ledit substrat au cours de ladite période de traitement, et
d'utiliser des informations des différences entre des informations de position mesurées de ladite pluralité de zones et des informations de position calculées obtenues en utilisant ladite pluralité desdites secondes formules de calcul mémorisées pour calculer des informations de position de la pluralité de zones de manière à sélectionner une seconde formule de calcul spécifique à partir de la pluralité de secondes formules de calcul.

**12.** Procédé d'exposition selon la revendication 10, comportant en outre,
de détecter des informations sur les tendances d'agencement de ladite pluralité de zones sur ledit substrat (W) au cours de ladite période de traitement, et
de sélectionner une seconde formule de calcul spécifique parmi la pluralité de secondes formules de calcul sur la base des informations détectées de tendances d'agencement.

**13.** Procédé d'exposition selon la revendication 4, comportant en outre, au cours de ladite période d'enregistrement, d'utiliser des informations des différences entre lesdites informations de position calculées obtenues en utilisant une pluralité de secondes formules de calcul pour lesquelles des coefficients sont déterminés pour chaque condition afin de calculer lesdites informations de position de la pluralité de zones et lesdites informations de position mesurées de manière à mémoriser de manière sélective une seconde formule de calcul spécifique.

**14.** Procédé d'exposition selon la revendication 1, dans lequel des informations de position d'une pluralité de zones d'impact sur un substrat (W) sont calculées et des motifs prédéterminés sur chaque zone d'impact sont exposés tout en commandant la position dudit substrat sur la base desdites informations de position calculées, incluant une étape (S501) consistant à sélectionner au moins une condition de correction pour corriger une erreur d'alignement non linéaire d'une pluralité de conditions de correction préparées à l'avance pour chaque condition d'une pluralité de conditions de traitement en vue d'un traitement d'exposition du substrat (W),
une étape (S503) consistant à sélectionner au moins une formule de modèle de second ordre ou d'ordre supérieur parmi une pluralité de formules, pour lesquelles des coefficients sont déterminés, mémorisées à l'avance dans un dispositif de mémorisation,

une étape de lecture des données antérieures mémorisées à l'avance sur un dispositif de mémorisation et concernant des résultats de commande de position du substrat (W) sur lequel un premier traitement est exécuté sous une condition sélectionnée parmi lesdites conditions de traitement,

une étape (S504) consistant à traiter lesdits résultats de commande de position sur la base de données spécifiant ladite formule de modèle de second ordre ou d'ordre supérieur sélectionnée, de ladite condition de traitement sélectionnée, et desdits résultats de commande de position lus, et à utiliser les résultats de traitement pour trouver lesdits coefficients de ladite formule de modèle de second ordre ou d'ordre supérieur, et à calculer la formule du second ordre ou d'ordre supérieur pour trouver des informations de position de la pluralité de zones d'impact sur ledit substrat,

une étape consistant à répéter l'étape (S504) de calcul de ladite formule de second ordre ou d'ordre supérieur tout en changeant au moins l'une de ladite condition de correction et de ladite formule de modèle de second ordre ou d'ordre supérieur et à mémoriser dans un dispositif de mémorisation au moins une formule parmi la pluralité de formules de second ordre ou d'ordre supérieur calculées conjointement avec les conditions de traitement associées audit premier traitement,

une étape consistant à extraire des données concernant des résultats d'alignement antérieur du substrat (W) soumis à un second traitement différent dudit premier traitement et mémorisées à l'avance dans ledit dispositif de mémorisation, à calculer la formule de second ordre ou d'ordre supérieur pour ledit second traitement de la même manière que pour calculer la formule de second ordre ou d'ordre supérieur correspondant audit premier traitement, et à mémoriser dans un dispositif de mémorisation la formule de second ordre ou d'ordre supérieur calculée conjointement avec la condition de traitement associée audit second traitement, et

lors d'une nouvelle exécution d'une commande de position pour le substrat (W) soumis au premier traitement, extraire la formule de second ordre ou d'ordre supérieur et les conditions de traitement mémorisées dans ledit dispositif de mémorisation associées audit premier traitement, utiliser ladite formule de second ordre ou d'ordre supérieur extraite et les conditions de traitement pour trouver les informations de position de la pluralité de zones d'impact sur ledit substrat, et exposer des motifs prédéterminés sur la pluralité de zones d'impact sur ledit substrat tout en commandant la position dudit substrat.

15. Procédé d'exposition selon la revendication 14, dans lequel
la commande de la position dudit substrat inclut une étape consistant à utiliser de manière sélective des données de détection d'un nombre prédéterminé de zones d'impact parmi la pluralité de zones d'impact sur le substrat, et lesdites conditions de traitement incluent un élément concernant le nombre de zones d'impact dans lesquelles les données de détection sont utilisées.

16. Procédé d'exposition selon la revendication 14, dans lequel
la commande de la position dudit substrat inclut une étape consistant à utiliser de manière sélective des données de détection de zones d'impact formées selon un agencement prédéterminé parmi la pluralité de zones d'impact sur le substrat, et lesdites conditions de traitement incluent un élément concernant l'agencement de zones d'impact dans lesquelles les données de détection sont utilisées.

17. Procédé d'exposition selon la revendication 14, dans lequel
la commande de la position dudit substrat inclut une étape consistant à détecter les images de marques formées correspondant à une pluralité de zones sur le substrat, et lesdites conditions de traitement incluent un élément concernant le procédé d'analyse de la forme d'onde de signaux desdites images.

18. Procédé d'exposition selon la revendication 14, dans lequel ledit modèle de second ordre ou d'ordre supérieur est l'un parmi une formule de modèle à 6 paramètres, une formule de modèle à 10 paramètres, et une formule de modèle de mise en moyenne d'impacts.

19. Procédé d'exposition selon la revendication 14, dans lequel il existe une pluralité d'ensembles de formules de second ordre ou d'ordre supérieur et de conditions de traitement mémorisées dans ledit dispositif de mémorisation associées à des traitements pour chaque traitement.

20. Procédé d'exposition selon la revendication 19, comportant en outre,
lors d'une nouvelle commande de la position d'un substrat, de détecter un nombre spécifique de zones d'impact parmi une pluralité de zones formées sur ledit substrat, et
de sélectionner une formule de second ordre ou d'ordre supérieur spécifique et une condition de traitement à partir de ladite pluralité d'ensembles de formules de second ordre ou d'ordre supérieur et de conditions de traitement mémorisées dans ledit dispositif de mémorisation associées à des traitements sur la base des résultats de détection de ladite pluralité de nombres de zones d'impact.

21. Procédé de production d'un dispositif par un substrat (W) exposé avec des motifs prédéterminés incluant une étape consistant à exposer ledit substrat auxdits motifs prédéterminés par l'intermédiaire d'un procédé d'exposition selon l'une quelconque des revendications précédentes.

22. Procédé d'affichage d'informations concernant une commande de position sur un écran d'affichage dans un procédé d'exposition calculant des informations de position d'une pluralité de zones d'impact sur un substrat (W) et exposant des motifs prédéterminés sur chaque zone d'impact tout en commandant la position dudit substrat sur la base desdites informations de position calculées, incluant
une étape (S501) consistant à sélectionner au moins une condition de correction pour corriger une erreur d'alignement non linéaire d'une pluralité de conditions de correction préparées à l'avance pour chaque condition de la pluralité de conditions de traitement en vue d'un traitement d'exposition du substrat (W),
une étape (S503) consistant à sélectionner au moins une formule de second ordre ou d'ordre supérieur parmi une pluralité de formules pour lesquelles des coefficients sont mémorisés à l'avance dans un dispositif de mémorisation,
une étape consistant à lire des données antérieures mémorisées à l'avance sur un dispositif de mémorisation et concernant des résultats de commande de position du substrat (W) sur lequel un premier traitement est exécuté sous une condition sélectionnée parmi lesdites conditions de traitement,
une étape (S504) consistant à traiter lesdits résultats de commande de position sur la base de données spécifiant ladite formule de modèle de second ordre ou d'ordre supérieur sélectionnée, ladite condition de traitement sélectionnée, et lesdits résultats de commande de position lus, et à utiliser les résultats de traitement pour trouver lesdits coefficients de ladite formule de modèle de second ordre ou d'ordre supérieur, et à calculer la formule de second ordre ou d'ordre supérieur pour trouver des informations de position de la pluralité de zones d'impact sur ledit substrat,
une étape consistant à répéter l'étape (S504) de calcul de ladite formule de second ordre ou d'ordre supérieur tout en changeant au moins l'une de ladite condition de correction et de ladite formule de modèle de second ordre ou d'ordre supérieur et à mémoriser dans un dispositif de mémorisation au moins l'une de la pluralité de formules de second ordre ou d'ordre supérieur calculées conjointement avec la condition de traitement associée audit premier traitement,
une étape consistant à extraire des données concernant des résultats d'alignement antérieur du substrat (W) soumis à un second traitement différent dudit premier traitement et mémorisé à l'avance dans ledit dispositif de mémorisation, à calculer la formule de second ordre ou d'ordre supérieur pour ledit second traitement de la même manière que pour calculer la formule de second ordre ou d'ordre supérieur correspondant audit premier traitement, et à mémoriser dans un dispositif de mémorisation la formule de second ordre ou d'ordre supérieur calculée conjointement avec la condition de traitement associée audit second traitement, et
lors d'une nouvelle exécution d'une commande de position pour le substrat (W) soumis au premier traitement, extraire la formule de second ordre ou d'ordre supérieur et une condition de traitement mémorisée dans ledit dispositif de mémorisation associée audit premier traitement, utiliser ladite formule de second ordre ou d'ordre supérieur extraite et une condition de traitement pour trouver les informations de position de la pluralité de zones d'impact sur ledit substrat, et afficher lesdites informations de position trouvées sur ledit écran d'affichage.

23. Procédé d'affichage selon la revendication 22, comportant en outre d'afficher les informations de position trouvées conjointement avec une image de l'image de substrat et des images de zones d'impact agencées sur l'image de ladite image de substrat.

24. Procédé d'affichage selon la revendication 22, comportant en outre d'afficher les informations de position trouvées par l'intermédiaire de valeurs numériques.

25. Procédé d'affichage selon la revendication 22, comportant en outre d'afficher un histogramme basé sur les informations de position trouvées.

26. Procédé d'exposition exposant des motifs prédéterminés sur un substrat incluant le procédé d'affichage selon la revendication 22, dans lequel il existe une pluralité d'ensembles de formules de second ordre ou d'ordre supérieur et de conditions de traitement mémorisées dans ledit dispositif de mémorisation associées à des traitements pour chaque traitement.

27. Procédé d'exposition selon la revendication 26, comportant en outre de sélectionner une formule de second ordre ou d'ordre supérieur spécifique et une condition de traitement parmi ladite pluralité d'ensembles de formules de second ordre ou d'ordre supérieur et de conditions de traitement mémorisées dans ledit dispositif de mémorisation associées à des traitements sur la base des informations de position affichées sur ledit écran d'affichage.

# FIG. 1

EP 1 603 153 B1

# FIG. 2

# FIG. 3

EP 1 603 153 B1

# FIG. 4a    FIG. 4b
### OFFSET
$\Delta dx = C_{X00}$        $\Delta dx = C_{Y00}$

# FIG. 4c    FIG. 4d
### MAGNIFICATION
$\Delta dx = C_{X10} \cdot x$        $\Delta dx = C_{Y10} \cdot y$

# FIG. 4e    FIG. 4f
### RHOMBIC
$\Delta dx = C_{X01} \cdot y$        $\Delta dx = C_{Y01} \cdot x$

# FIG. 4g    FIG. 4h
### OFF-CENTERED MAGNIFICATION
$\Delta dx = C_{X20} \cdot x^2$        $\Delta dx = C_{Y02} \cdot y^2$

# FIG. 4i    FIG. 4j
### TRAPEZOIDAL
$\Delta dx = C_{X11} \cdot x \cdot y$        $\Delta dx = C_{Y11} \cdot x \cdot y$

# FIG. 4k    FIG. 4ℓ
### DOOR-SHAPED
$\Delta dx = C_{X02} \cdot y^2$        $\Delta dx = C_{Y20} \cdot x^2$

# FIG. 4m    FIG. 4n
### C-MAGNIFICATION
$\Delta dx = C_{X30} \cdot x^3$        $\Delta dx = C_{Y03} \cdot y^3$

# FIG. 4o    FIG. 4p
### ACCORDIAN
$\Delta dx = C_{X21} \cdot x^2 \cdot y$        $\Delta dx = C_{Y12} \cdot x \cdot y^2$

# FIG. 4q    FIG. 4r
### C-DISTORTION
$\Delta dx = C_{X12} \cdot x \cdot y^2$        $\Delta dx = C_{Y21} \cdot x^2 \cdot y$

# FIG. 4s    FIG. 4t
### RIVERFLOW
$\Delta dx = C_{X03} \cdot y^3$        $\Delta dx = C_{Y30} \cdot x^3$

# FIG. 5

START

SET CONDITION (RESULT FILE, CALCULATION MODEL, ORDER, CORRECTION COEFFICIENT) — S501

DESIGNATE CALCULATION MODEL — S502

DESIGNATE ORDER AND CORRECTION COEFFICIENTS — S503

CALCULATE HIGHER ORDER EGA CORRECTION COEFFICIENTS — S504

CALCULATION FINISHED FOR DESIGNATED NUMBER OF WAFERS ? — S505
NO

YES

REJECT WAFER DATA — S506

CALCULATION FINISHED FOR COMBINATION OF ORDERS AND CORRECTION COEFFICIENTS ? — S507
NO

YES

CALCULATION FINISHED FOR CALCULATION MODELS ? — S508
NO

YES

AVERAGE HIGHER ORDER CORRECTION COEFFICIENTS FOR EACH CONDITION — S509

SELECT HIGHER ORDER CORRECTION COEFFICIENT — S510

END

# FIG. 6

START

**S601** HIGHER ORDER EGA ROUGHNESS MEASUREMENT FUNCTION ON ? — NO

YES

**S604** WAFER COVERED BY HIGHER ORDER EGA ROUGH MEASUREMENT ? — NO

YES

**S607** HIGHER ORDER EGA ROUGH MEASUREMENT

**S608** DETERMINE OPTIMUN CONDITIONS

**S609** NORMAL EGA MEASUREMENT ON MEASURED SHOTS

**S605** NORMAL EGA MEASUREMENT

**S602** NORMAL EGA MEASUREMENT

**S610** SELECT CORRECTION COEFFICIENT CORRESPONDING TO OPTIMUM CONDITIONS FROM PRE-REGISTERED HIGHER ORDER CORRECTION COEFFICIENTS

**S606** SELECT HIGHER ORDER CORRECTION COEFFICIENT USED IN EXPOSURE OF PREVIOUS WAFER

**S603** SELECT CORRECTION COEFFICIENT DESIGNATED FROM PRE-REGISTERED COEFFICIENTS

**S611** EXPOSE USING HIGHER ORDER CORRECTION COEFFICIENT AS RESULT OF NORMAL EGA

**S612** EXPOSURE FINISHED FOR ALL WAFERS ? — NO

YES

END

EP 1 603 153 B1

# FIG. 7

# FIG. 8

DESIGN
(FUNCTIONS, PERFORMANCE, PATTERNS) — S810

PRODUCE WAFER — S830

FABRICATE MASK — S820

PROCESS WAFER — S840

FORM FILM — S841

FORM RESIST — S842

EXPOSE — S843

DEVELOP — S844

ETCH — S845

REMOVE RESIST — S846

ASSEMBLE DEVICE — S850

INSPECT — S860

(SHIPMENT)

EP 1 603 153 B1

# FIG. 9A

200-1 | 200-n | 130 | 160

EXPOSURE APPARATUS · · · · EXPOSURE APPARATUS | OVERLAY MEASUREMENT DEVICE | INFORMATION SERVER

· · · ·

140 — HOST COMPUTER | PC

110

100

150

# FIG. 9B

110

200-1 — EXPOSURE APPARATUS

141 | 170 | 180

CONTROL DEVICE | SERVER

200-n — EXPOSURE APPARATUS

103

130 — OVERLAY MEASUREMENT DEVICE

102

37

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP S6144429 B
- JP S6284516 B
- US 5986766 A
- US 5863680 A
- JP H10112433 B
- JP H6349701 B

- JP H254103 B
- JP H5190423 B
- JP H6283403 B
- JP H4324615 B
- JP 2003049421 A